# EUROPEAN PATENT APPLICATION

(11) **EP 2 927 900 A1**
(43) Date of publication of application: **07.10.2015**
(21) Application number: 13858651.6
(22) Date of filing: 31.05.2013
(51) Int. Cl.: G09G 3/32

(54) **LED DISPLAY DEVICE**

(30) Priority: 29.11.2012 CN 201210501884
(71) Applicant: Leyard Optoelectronic Co., Ltd, Beijing 100091 (CN)
(72) Inventor: LU, Changjun, Beijing 100091 (CN); LIU, Zhiyong, Beijing 100091 (CN)
(74) Representative: Hewett, Jonathan Michael Richard
(86) International application number: PCT/CN2013/076604
(87) International publication number: WO 2014/082433

(57) **Abstract**

The invention discloses a Light-Emitting Diode (LED) display, which includes: an LED display panel (10); and a display driving circuit (30), the display driving circuit (30)includes a driving circuit (33) and a control circuit (35), the driving circuit (33) includes a first constant current channel group (331), a second constant current channel group (333) and a third constant current channel group (335), wherein the first constant current channel group (331) controls the display of red lamp tubes of the LED display panel (10); the second constant current channel group (333) controls the display of green lamp tubes of the LED display panel (10); the third constant current channel group (335) controls the display of blue lamp tubes of the LED display panel (10); the control circuit (35) includes a driving control circuit (353), the driving control circuit (353) is configured to control the switching-on or switching-off of the driving circuit (33). The driving circuit (33) and the control circuit (35) are integrated in the display driving circuit (30), and the driving circuit (33) includes the three constant current channel groups which control the ordered display of the LEDs in three primary colors in an LED particle array respectively, so that the effects of small panel area occupied by the control circuit (35), simple design, high refresh rate and low power consumption of the LED display are achieved.

## Description

### Technical field of the invention

The invention relates to the field of Light-Emitting Diode (LED) equipment, in particular to an LED display.

### Background of the invention

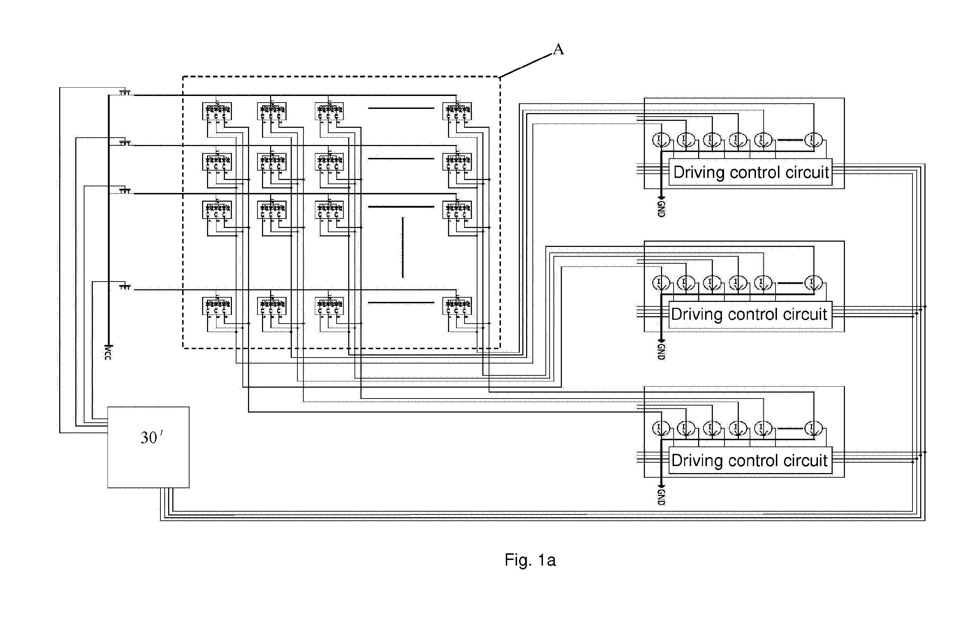

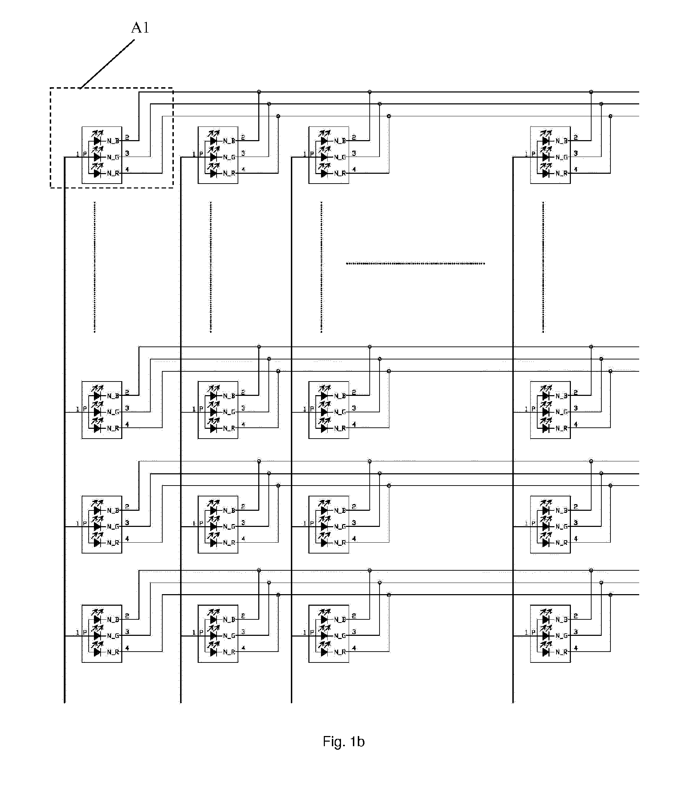

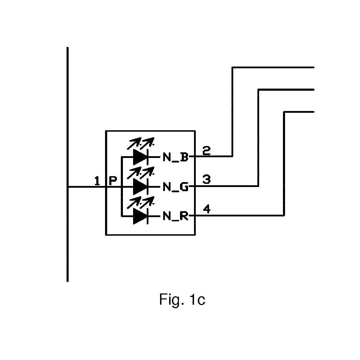

At present, a discrete placement mode is adopted for LEDs, P-channel Metal Oxide Semiconductor (P-MOS) transistors and an LED driving circuit during the design of a unit board of an LED display. As shown in Fig. 1b: LED particles in Fig. 1 b are four-pin Red/Green/Blue (R/G/B) common-anode three-in-one LEDs, pins 1 are common anodes, and pins 2/3/4 are cathodes of the B/G/R three primary colors LEDs respectively; and external display driving circuit 30', one of control ports of the external display driving circuit 30' is a constant current control signal output port, another of the control ports is a line power supply control port, and the constant current control signal output port is matched with the line power supply control port to realize the display work of an LED array.

Fig. 1a to Fig. 1c are discrete placement diagrams of an LED driving circuit for common-anode three-in-one LED particles in related art. As shown in Fig. 1 a, the LED driving circuit includes three logic circuits and corresponding constant current channel groups, i.e. LED driving control circuits for controlling R/G/B display in the LED unit board respectively, and the three integrated circuits have the same internal architecture, and drive the display of the LED array under the control of the external display driving circuit 30'. A present LED driving circuit includes multiple independent constant current logic components forming a constant current array; each constant current logic component consists of a constant current input end, a constant current output end and a constant current control end, the constant current output ends of the constant current array are connected with an external pin GND of the LED driving circuit respectively; the constant current array is controlled by a internal logic circuits of the LED driving circuit in a unified way to realize the ordered work of each independent constant current logic component and control the display of external LEDs; the internal logic circuit also includes two parts, i.e. an LED driving circuit input signal port and an output signal port, wherein the input signal port is connected to the constant current control signal output port of the external display driving circuit 30', and the output signal port is used for cascading input signal port of an LED driving circuit of the next stage or are idled; and P-MOS components shown in Fig. 1c are controlled by the line power supply control port to realize line-by-line power supply control of the LED array.

The LED unit board consists of an LED matrix with M lines and N columns, anodes of the LEDs in a single line are interconnected to drains of the P-MOS transistors, and a common cathode of primary colors of the LEDs in a single column is interconnected to a constant current input end of the LED driving circuit; sources of the P-MOS transistors are connected to a power supply end VCC, and gates of the P-MOS transistors are connected to the line power supply control port; and under the control of the display driving circuit 30', the drain of a certain P-MOS transistor is switched on to supply power to the anodes of the LEDs in the corresponding line, the constant current control signal output port controls the logic circuits of the LED driving circuit to control the ordered conduction of the constant current array and realize the ordered conduction of the current of the LEDs in the line to GND to realize the ordered switching-on of the LEDs.

From the above, the P-MOS transistors, the LED driving circuit and the display driving circuit 30' are independently encapsulated electronic components, and a Printed Circuit Board (PCB) area occupied by the P-MOS transistors, the LED driving circuit and the display driving circuit 30' for the LED array display of a certain resolution under the conditions of a certain scanning mode and a certain P-MOS transistor load is a fixed value, that is, the PCB area occupied by the components is a fixed value, which inevitably brings the problems of low refresh rate and high design difficulty during application to a control mode of a high-density LED display.

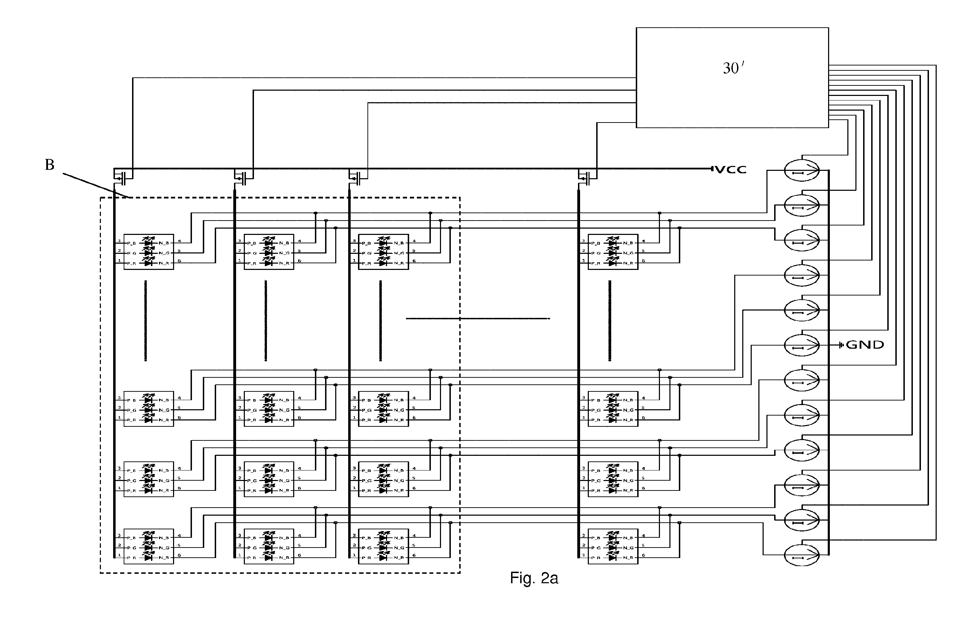

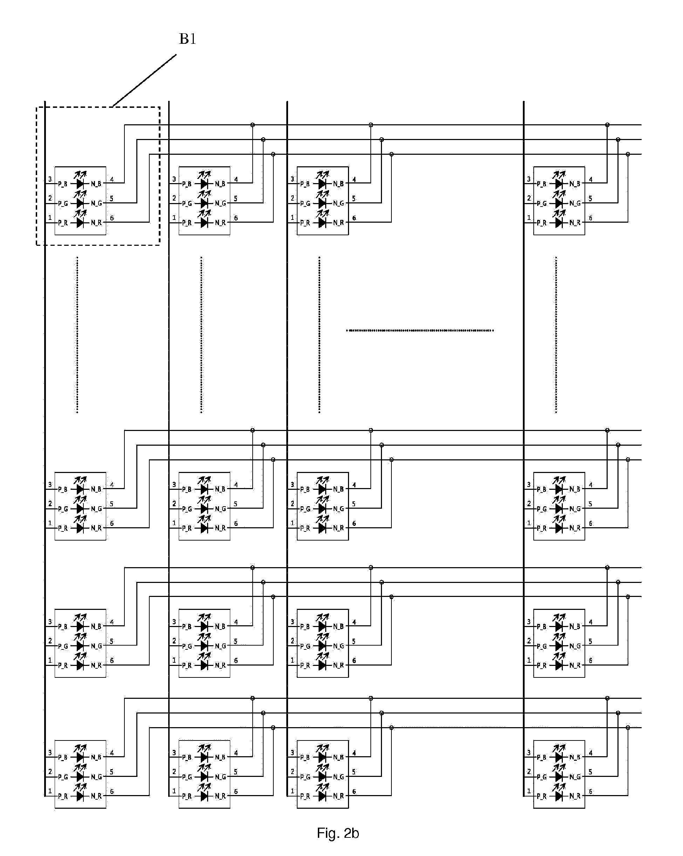

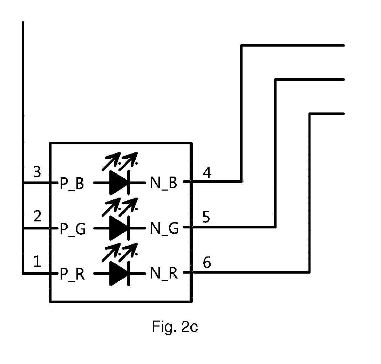

In addition, Fig. 2a to Fig. 2c are discrete placement circuit diagrams of an LED driving circuit for 6-pin R/G/B three-in-one LEDs in related art. Wherein, an anode of each 6-pin R/G/B three-in-one LED in Fig. 2b has three pins, i.e. 1, 2 and 3 respectively, corresponding to anodes of internal R/G/B respectively, and a cathode of each 6-pin R/G/B three-in-one LED has three pins, i.e. 4, 5 and 6 respectively, corresponding to cathodes of internal R/G/B respectively; the LED unit board consists of an LED matrix with M lines and N columns, the anodes of the LEDs in a single line are interconnected to the drains of the P-MOS transistors, and a common primary color cathode of the LEDs in a single column is interconnected to the input end of the LED driving circuit; the sources of the P-MOS transistors are connected to the power supply end VCC, the gates of the P-MOS transistors are connected to a power supply control logic part of the display driving circuit 30', and the drains of the P-MOS transistors are connected to the anodes of a group of LEDs (the LEDs in Fig. 2b are LEDs in a single line, which the group definition is not purely defined into one line actually) of the LED unit board; the control end of the LED driving control circuit is connected with a branch of an LED driving circuit control part, and driving current for switching on the LEDs flows through the input end of the LED driving circuit and the output end of the LED driving circuit to reach the GND from the cathodes (pins 4, 5 and 6) of the LEDs; and the display driving circuit 30' includes a line power supply control logic part and the LED driving circuit control part, and under the control of the display driving circuit 30', the display work of the LED unit board is realized.

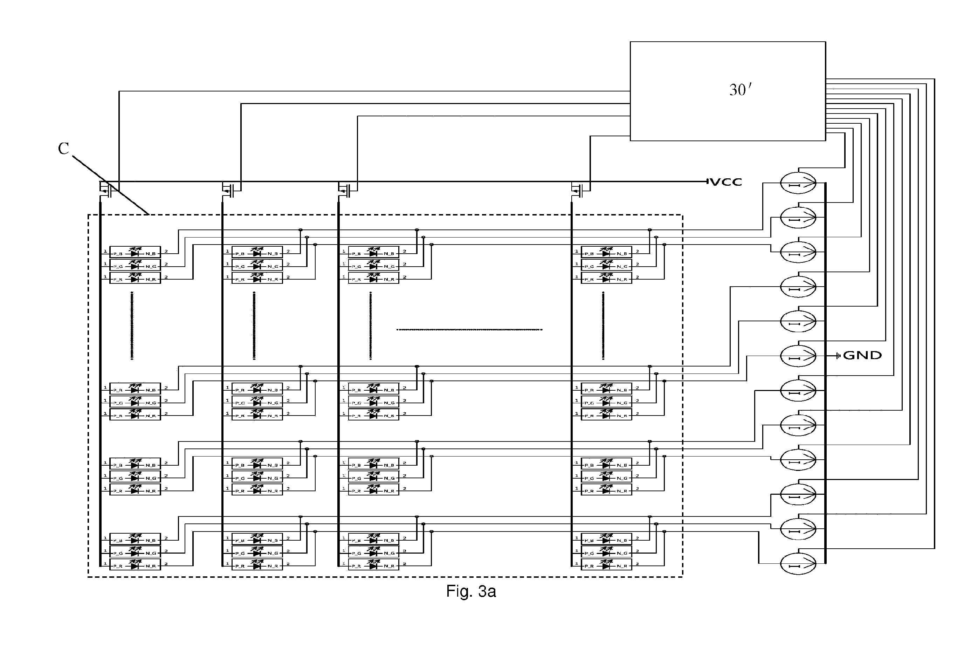

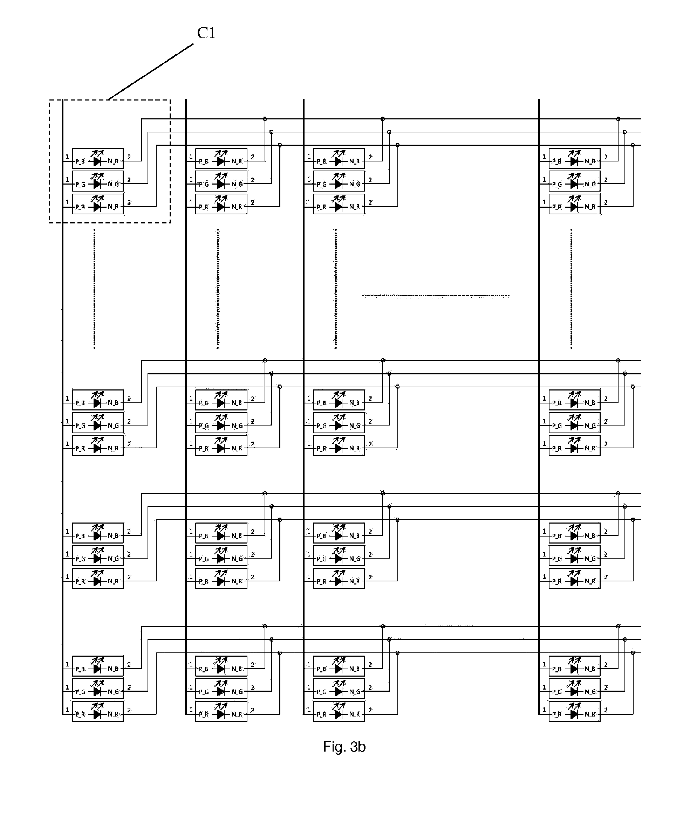

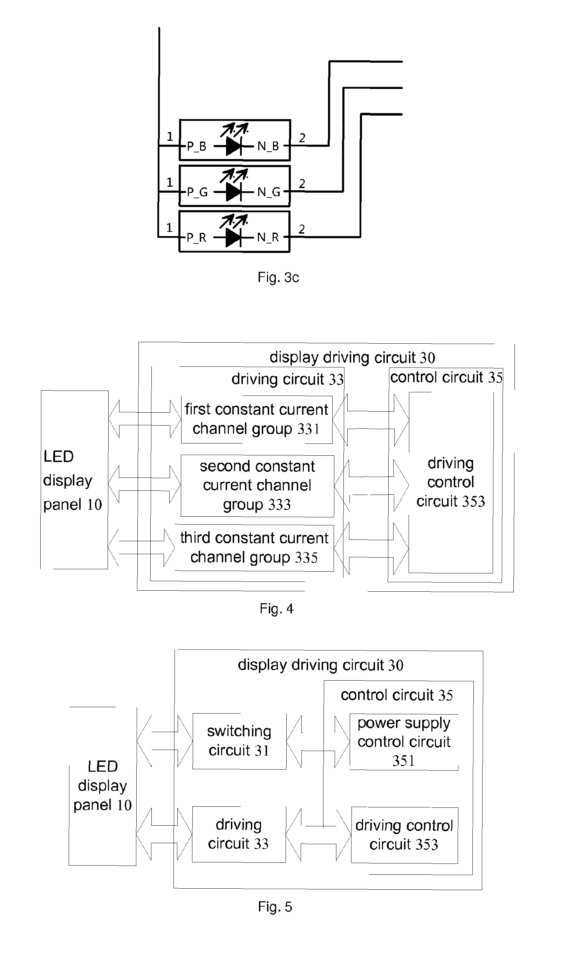

Fig. 3a to Fig. 3c are discrete placement circuit diagrams of an LED driving circuit for R/G/B independent LEDs in related art. As shown in Fig. 3b, an anode of an R/G/B independent LED particle is pin 1, a cathode of the R/G/B independent LED particle is pin 2, and R/G/B are welded in parallel to form a full-color pixel during application; the LED unit board consists of an LED matrix with M lines and N columns, the anodes of the LEDs in a single line are interconnected to the drains of the P-MOS transistors, and the common primary color cathode of the LEDs in a single column is interconnected to the input end of the LED driving control circuit; the sources of the P-MOS transistors are connected to the power supply end VCC, the gates of the P-MOS transistors are connected to the power supply control logic part of the display driving circuit 30', and the drains of the P-MOS transistors are connected to the anodes of a group of LEDs (the LEDs in Fig. 3a are LEDs in a single line, which the group definition is not purely defined into a line actually) of the LED unit board; the control end of the LED driving circuit is connected with a branch of an LED driving circuit control part, and the driving current for switching on the LEDs flows through the input end of the LED driving circuit and the output end of the LED driving circuit to reach the GND from the cathodes (pins 2) of the LED particles; and the display driving circuit 30' includes a line power supply control logic part and the LED driving circuit control part, and under the control of the display driving circuit 30', the display work of the LED unit board is realized.

From the above, the R/G/B LEDs have different working voltages, wherein a typical working voltage of R LEDs is 1.8-2V, and typical working voltages of G/B LEDs are 3.4-3.6V, so that output voltages of the P-MOS transistors must be higher than the sum of the typical voltages of the G/B LEDs and a typical constant current voltage of the LED driving circuit to ensure that working voltages of the G/B LEDs are normal. Thus, voltage differences of the R LEDs relative to the G/B LEDs are applied to the LED driving circuit to generate heat for dissipation, which causes high power consumption of the LED display.

For the problems of large PCB area occupied by the control circuits, low refresh rate and high power consumption of the LED display in related art, there is yet no effective solution.

### Summary of the invention

For the problems of large PCB area occupied by a control circuit, low refresh rate and high power consumption of an LED display in a related art, there is yet no effective solution. Therefore, a main purpose of the invention is to provide an LED display, so as to solve the problems.

In order to achieve the purpose, according to one aspect of the invention, an LED display is provided, which includes: an LED display panel; and a display driving circuit, the display driving circuit includes a driving circuit and a control circuit, the driving circuit includes a first constant current channel group, a second constant current channel group and a third constant current channel group, wherein the first constant current channel group includes one or more constant current logic components, a first end of each constant current logic component is connected with a power end of a first power supply equipment respectively, a third end of each constant current logic component is connected with a first R display control sub-port of a driving control port of the control circuit respectively, and a second end of each constant current logic component is connected with a cathode of an red lamp tube in each LED particle in a corresponding column in the LED display panel respectively, and is configured to control display of red lamp tubes of the LED display panel; the second constant current channel group includes one or more constant current logic components, wherein a first end of each constant current logic component is connected with a power end of a second power supply equipment, a third end of each constant current logic component is connected with a first G display control sub-port of the driving control port of the control circuit respectively, and a second end of each constant current logic component is connected with a cathode of a green lamp tube in each LED particle in a corresponding column in the LED display panel respectively, and is configured to control display of green lamp tubes of the LED display panel; the third constant current channel group includes one or more constant current logic components, wherein a first end of each constant current logic component is connected with a power end of a third power supply equipment respectively, a third end of each constant current logic component is connected with a first B display control sub-port of the driving control port of the control circuit respectively, and a second end of each constant current logic component is connected with a cathode of a blue lamp tube in each LED particle in a corresponding column in the LED display panel respectively, and is configured to control display of blue lamp tubes of the LED display panel; the control circuit includes a driving control circuit, wherein the driving control circuit is connected with a third end of the driving circuit through the driving control port, and is configured to control switching-on or switching-off of the driving circuit; and the driving circuit is configured to control ordered display of the LED display panel.

Furthermore, the driving control circuit is configured to control each constant current logic component in the first constant current channel group to be switched on through the first R display control sub-port, and each constant current logic component provides a current path for the red lamp tubes in the LED particles in the column corresponding to the constant current logic component in the LED display panel to control the display of the red lamp tubes of the LED particles in the line corresponding to a field effect transistor in the LED display panel after being switched on respectively; the driving control circuit is further configured to control each constant current logic component in the second constant current channel group to be switched on through the first G display control sub-port, and each constant current logic component provides a current path for the green lamp tubes in the LED particles in the column corresponding to the constant current logic component in the LED display panel to control the display of the green lamp tubes of the LED particles in the line corresponding to the field effect transistor in the LED display panel after being switched on respectively; and the driving control circuit is further configured to control each constant current logic component in the third constant current channel group to be switched on through the first B display control sub-port, and each constant current logic component provides a current path for the blue lamp tubes in the LED particles in the column corresponding to the constant current logic component in the LED display panel to control the display of the blue lamp tubes of the LED particles in the line corresponding to the field effect transistor in the LED display panel after being switched on respectively.

Furthermore, the display driving circuit further includes: a switching circuit, wherein a first end of the switching circuit is connected to the grounding end of the power supply equipment, and a second end of the switching circuit is connected with an anode of the LED display panel; the control circuit further includes a power supply control circuit, wherein the power supply control circuit is connected with a third end of the switching circuit through a power supply control port, and is configured to control the switching-on or switching-off of the switching circuit; and the switching circuit is configured to control the power supply of the LED display panel.

Furthermore, the switching circuit includes one switching sub-circuit, and the switching sub-circuit includes one or more field effect transistors, wherein a source of each field effect transistor is connected with the grounding end of the power supply equipment respectively; a drain of each field effect transistor is connected with a cathode of each LED particle in a corresponding line in the LED display panel respectively; and a gate of each field effect transistor is connected with a corresponding connection terminal in the power supply control port respectively.

Furthermore, the power supply control circuit is configured to control each field effect transistor to be switched on to supply power to the LED particles in the lines corresponding to the field effect transistors in the LED display panel.

Furthermore, the field effect transistors are N-channel Metal Oxide Semiconductor (N-MOS) transistors, the LED display panel includes M lines and N columns of LED particles, and each LED particle includes the red lamp tube, the green lamp tube and the blue lamp tube respectively, wherein the cathode of the red lamp tube, the cathode of the green lamp tube and the cathode of the blue lamp tube in an ith LED particle in each line are connected in parallel with an ith joint, and each joint in each line is connected in parallel, and is connected with a drain of a corresponding N-MOS transistor in the switching circuit respectively; the anode of the red lamp tube of each LED particle in each column is connected in parallel respectively, and is connected with the second end of a corresponding constant current logic component in the first constant current channel group as a connection terminal of the anode of the LED display panel respectively; the anode of the green lamp tube of each LED particle in each column is connected in parallel respectively, and is connected with the second end of a corresponding constant current logic component in the second constant current channel group as a connection terminal of the anode of the LED display panel respectively; and the anode of the blue lamp tube of each LED particle in each column is connected in parallel respectively, and is connected with the second end of a corresponding constant current logic component in the third constant current channel group as a connection terminal of the anode of the LED display panel respectively.

Furthermore, the field effect transistors are N-MOS transistors, the LED display panel includes M lines and N columns of LED particles, and each LED particle includes the red lamp tube, the green lamp tube and the blue lamp tube, wherein the cathode of the red lamp tube, the cathode of the green lamp tube and the cathode of the blue lamp tube in each LED particle in each line are connected in parallel, and are connected with the drain of a corresponding N-MOS transistor in the switching circuit respectively; the anode of the red lamp tube of each LED particle in each column is connected in parallel respectively, and is connected with the second end of a corresponding constant current logic component in the first constant current channel group respectively; the anode of the green lamp tube of each LED particle in each column is connected in parallel respectively, and is connected with the second end of a corresponding constant current logic component in the second constant current channel group; and the anode of the blue lamp tube of each LED particle in each column is connected in parallel respectively, and is connected with the second end of a corresponding constant current logic component in the third constant current channel group respectively.

Furthermore, the switching circuit includes a first switching sub-circuit and a second switching sub-circuit, wherein the first switching sub-circuit includes one or more field effect transistors, a source of each field effect transistor is connected with the grounding end of the power supply equipment respectively, a drain of each field effect transistor is connected with the cathode of the red lamp tube in each LED particle in the corresponding line in the LED display panel respectively, and a gate of each field effect transistor is connected with the corresponding connection terminal in the power supply control port respectively, and is configured to control the power supply of the red lamp tubes of the LED display panel; and the second switching sub-circuit includes one or more field effect transistors, a source of each field effect transistor is connected with the grounding end of the power supply equipment respectively, a drain of each field effect transistor is connected with the cathodes of the green lamp tube and the blue lamp tube in each LED particle in the corresponding line in the LED display panel respectively, and a gate of each field effect transistor is connected with the corresponding connection terminal in the power supply control port, and is configured to control the power supply of the green lamp tubes and the blue lamp tubes of the LED display panel.

Furthermore, the power supply control circuit is configured to control one field effect transistor in the first switching sub-circuit to be switched on to supply power to the red lamp tubes in the LED particles in the line corresponding to the field effect transistor in the first switching sub-circuit in the LED display panel; the power supply control circuit is further configured to control the field effect transistor corresponding to the switched-on field effect transistor in the first switching sub-circuit in the second switching sub-circuit to be switched on to supply power to the green lamp tubes and the blue lamp tubes in the LED particles in the line corresponding to the field effect transistor in the first switching sub-circuit in the LED display panel; the driving control circuit is configured to control each constant current logic component in the first constant current channel group to be switched on through a second R display control sub-port, and each constant current logic component provides a current path for the red lamp tubes in the LED particles in the column corresponding to the constant current logic component in the LED display panel to control the display of the red lamp tubes of the LED particles in the line corresponding to the field effect transistor in the LED display panel respectively after being switched on; the driving control circuit is further configured to control each constant current logic component in the second constant current channel group to be switched on through a second G display control sub-port, and each constant current logic component provides a current path for the green lamp tubes in the LED particles in the column corresponding to the constant current logic component in the LED display panel to control the display of the green lamp tubes of the LED particles in the line corresponding to the field effect transistor in the LED display panel respectively after being switched on; and the driving control circuit is further configured to control each constant current logic component in the third constant current channel group to be switched on through a second B display control sub-port, and each constant current logic component provides a current path for the blue lamp tubes in the LED particles in the column corresponding to the constant current logic component in the LED display panel to control the display of the blue lamp tubes of the LED particles in the line corresponding to the field effect transistor in the LED display panel respectively after being switched on.

Furthermore, the field effect transistors are N-MOS transistors, the LED display panel includes M lines and N columns of LED particles, and each LED particle includes the red lamp tube, the green lamp tube and the blue lamp tube, wherein the cathode of the red lamp tube in an ith LED particle in each line is connected in parallel with an ith joint, and each joint in each line is connected in parallel, and is connected with the drain of a corresponding N-MOS transistor in the first switching sub-circuit respectively; the cathode of the green lamp tube and the cathode of the blue lamp tube in the jth LED particle in each line are connected in parallel with a jth joint, and each joint in each line is connected in parallel, and is connected with the drain of a corresponding N-MOS transistor in the second switching sub-circuit respectively; the anode of the red lamp tube of each LED particle in each column is connected in parallel, and is connected with the second end of a corresponding constant current logic component in the first constant current channel group respectively; the anode of the green lamp tube of each LED particle in each column is connected in parallel, and is connected with the second end of a corresponding constant current logic component in the second constant current channel group respectively; and the anode of the blue lamp tube of each LED particle in each column is connected in parallel, and is connected with the second end of a corresponding constant current logic component in the third constant current channel group respectively.

Furthermore, the field effect transistors are N-MOS transistors, the LED display panel includes M lines and N columns of LED particles, and each LED particle includes the red lamp tube, the green lamp tube and the blue lamp tube, wherein the cathode of the red lamp tube in each LED particle in each line is connected in parallel, and is connected with the drain of a corresponding N-MOS transistor in the first switching sub-circuit respectively; the cathode of the green lamp tube and the cathode of the blue lamp tube in each LED particle in each line are connected in parallel, and are connected with the drain of a corresponding N-MOS transistor in the second switching sub-circuit respectively; the anode of the red lamp tube of each LED particle in each column is connected in parallel, and is connected with the second end of a corresponding constant current logic component in the first constant current channel group respectively; the anode of the green lamp tube of each LED particle in each column is connected in parallel, and is connected with the second end of a corresponding constant current logic component in the second constant current channel group respectively; and the anode of the blue lamp tube of each LED particle in each column is connected in parallel, and is connected with the second end of a corresponding constant current logic component in the third constant current channel group respectively.

Furthermore, the LED particles in the LED display panel include the red lamp tubes, the green lamp tubes and the blue lamp tubes, wherein the red lamp tubes, the green lamp tubes and the blue lamp tubes are integrated in the LED particles; or, the red lamp tubes, the green lamp tubes and the blue lamp tubes are arranged in the LED particles after being independently encapsulated respectively.

By the LED display of the invention, the driving circuit and the control circuit are integrated in the display driving circuit, and then more display driving circuits can be placed under the condition of not changing the area of the LED display panel, so that the number ratio of the LED particles to the display driving circuits on the LED display with a fixed area is reduced, and the refresh rate is increased; moreover, the driving circuit includes the first constant current channel group, the second constant current channel group and the third constant current channel group, and the three constant current channel groups control the ordered display of the R/G/B LEDs in an LED particle array with M lines and N columns in the LED display panel respectively, and provide different working voltages for the red lamp tubes and the green/blue lamp tubes of the LED particles in the LED display panel respectively, so that the power consumption of the LED display can be lowered. The problems of large PCB area occupied by the control circuit and low refresh rate of the LED display in related art are solved, and the effects of small PCB area occupied by the control circuit, simple design, high refresh rate and low power consumption of the LED display are achieved.

### Brief description of the drawings

The drawings are described here to provide further understanding of the invention, and form a part of the invention. The schematic embodiments and description of the invention are adopted to explain the invention, and do not form improper limits to the invention. In the drawings:
Fig. 1 a is a discrete placement diagram of an LED driving circuit for three-anode-in-one LED particles in related art;
Fig. 1 b is a drawing of partial enlargement of a dotted part A in Fig. 1 a;
Fig. 1 c is a drawing of partial enlargement of a dotted part A1 in Fig. 1b;
Fig. 2a is a discrete placement circuit diagram of an LED driving circuit for a 6-pin R/G/B three-in-one LED in related art;
Fig. 2b is a drawing of partial enlargement of a dotted part B in Fig. 2a;
Fig. 2c is a drawing of partial enlargement of a dotted part B1 in Fig. 2b;
Fig. 3a is a discrete placement circuit diagram of an LED driving circuit for an R/G/B independent LED in related art;
Fig. 3b is a drawing of partial enlargement of a dotted part C in Fig. 3a;
Fig. 3c is a drawing of partial enlargement of a dotted part C1 in Fig. 3b;
Fig. 4 is a structure diagram of an LED display according to embodiment 1 of the invention;
Fig. 5 is a structure diagram of an LED display according to a preferred embodiment of the invention;
Fig. 5a is a detailed structure diagram of an LED display according to the preferred embodiment of the invention shown in Fig. 5;
Fig. 5b is a drawing of partial enlargement of a dotted part D in Fig. 5a;
Fig. 5c is a drawing of partial enlargement of a dotted part D1 in Fig. 5b;
Fig. 6a is a structure diagram of an LED display according to embodiment 2 of the invention;
Fig. 6b is a drawing of partial enlargement of a dotted part E in Fig. 6a;
Fig. 6c is a drawing of partial enlargement of a dotted part E1 in Fig. 6b;
Fig. 7a is a structure diagram of an LED display according to embodiment 3 of the invention;
Fig. 7b is a drawing of partial enlargement of a dotted part F in Fig. 7a;
Fig. 7c is a drawing of partial enlargement of a dotted part F1 in Fig. 7b;
Fig. 7d is a drawing of partial enlargement of a switching circuit in a dotted part G in Fig. 7a;
Fig. 7e is a drawing of partial enlargement of a dotted part G1 in Fig. 7d;
Fig. 8a is a structure diagram of an LED display according to embodiment 4 of the invention;
Fig. 8b is a drawing of partial enlargement of a dotted part H in Fig. 8a;
Fig. 8c is a drawing of partial enlargement of a dotted part H1 in Fig. 8b;
Fig. 9a is a structure diagram of an LED display according to embodiment 5 of the invention;
Fig. 9b is a drawing of partial enlargement of a dotted part I in Fig. 9a;
Fig. 9c is a drawing of partial enlargement of a dotted part I1 in Fig. 9b;
Fig. 10a is a structure diagram of an LED display according to embodiment 6 of the invention;
Fig. 10b is a drawing of partial enlargement of a dotted part J in Fig. 10a;
Fig. 10c is a drawing of partial enlargement of a dotted part J1 in Fig. 10b;
Fig. 10d is a drawing of partial enlargement of a dotted part K in Fig. 10a;
Fig. 10e is a drawing of partial enlargement of a dotted part K1 in Fig. 10d; and
Fig. 11 is a structure diagram of an LED control system according to an embodiment of the invention.

### Detailed description of the embodiments

It should be noted that the embodiments of the invention and the characteristics in the embodiments can be combined under the condition of no conflicts. The invention is descried below with reference to the drawings and embodiments in detail.

### Embodiment 1:

Fig. 4 is a structure diagram of an LED display according to embodiment 1 of the invention. As shown in Fig. 4, the LED display includes: an LED display panel 10; and a display driving circuit 30, the display driving circuit 30 includes a driving circuit 33 and a control circuit 35, the driving circuit 33 includes a first constant current channel group 331, a second constant current channel group 333 and a third constant current channel group 335, wherein the first constant current channel group 331 includes one or more constant current logic components, wherein a first end of each constant current logic component is respectively connected with a power end of a first power supply equipment 51, a third end of each constant current logic component is respectively connected with a first R display control sub-port of a driving control port of the control circuit, and a second end of each constant current logic component is respectively connected with a cathode of an red lamp tube in each LED particle in a corresponding column in the LED display panel, and the first constant current channel group 331 is configured to control the display of the red lamp tubes of the LED display panel; the second constant current channel group 333 includes one or more constant current logic components, wherein a first end of each constant current logic component is respectively connected with a power end of a second power supply equipment 53, a third end of each constant current logic component is respectively connected with a first G display control sub-port of the driving control port of the control circuit, and a second end of each constant current logic component is respectively connected with a cathode of a green lamp tube in each LED particle in a corresponding column in the LED display panel, and the second constant current channel group 333 is configured to control the green lamp tubes of the LED display panel; the third constant current channel group 335 includes one or more constant current logic components, wherein a first end of each constant current logic component is respectively connected with a power end of a third power supply equipment, a third end of each constant current logic component is respectively connected with a first B display control sub-port of the driving control port of the control circuit, and a second end of each constant current logic component is respectively connected with a cathode of a blue lamp tube in each LED particle in a corresponding column in the LED display panel, and the third constant current channel group 335 is configured to control the blue lamp tubes of the LED display panel; the control circuit includes a driving control circuit; wherein the driving control circuit is connected with a third end of the driving circuit through the driving control port, and is configured to control the switching-on or switching-off of the driving circuit; and the driving circuit is configured to control the ordered display of the LED display panel.

By the LED display of the invention, the driving circuit 33 and the control circuit 35 are integrated in the display driving circuit 30, and then more display driving circuits 30 can be placed under the condition of not changing the area of the LED display panel 10, so that the number ratio of the LED particles to the display driving circuits 30 on the LED display with a fixed area is reduced, and the refresh rate is increased; moreover, the driving circuit 33 includes the first constant current channel group 331, the second constant current channel group 333 and the third constant current channel group 335, and the three constant current channel groups control the ordered display of the R/G/B LEDs in an LED particle array with M lines and N columns in the LED display panel 10 respectively, and provide different working voltages for the red lamp tubes and the green/blue lamp tubes of the LED particles in the LED display panel 10 respectively, so that the power consumption of the LED display can be lowered. The problems of large PCB area occupied by the control circuit 35 and low refresh rate of the LED display in related art are solved, and the effects of small PCB area occupied by the control circuit 35, simple design, high refresh rate and low power consumption of the LED display are achieved.

Wherein, the first power supply equipment, the second power supply equipment and the third power supply equipment are not shown in Fig. 4, a power supply voltage of the first power supply equipment for the first constant current channel group preferably is 1.6V, which is obtained by subtracting a typical working voltage (1.8-2V) of the red LEDs from a typical working voltages (3.4-3.6V) of the green/blue LEDs, and the power supply voltage of the first power supply equipment for the first constant current channel group is lower than respective power supply voltages of the second power supply equipment and the third power supply equipment for the second constant current channel group/the third constant current channel group.

The LED display can include: the LED display panel 10; and the display driving circuit 30, the display driving circuit 30 includes a switching circuit 31, the driving circuit 33 and the control circuit 35, wherein a first end of one of the switching circuit 31 and the driving circuit 33 is connected to a power end of power supply equipment, and a first end of the other of the switching circuit 31 and the driving circuit 33 is connected to a grounding end of the power supply equipment; a second end of one of the switching circuit 31 and the driving circuit 33 is connected with an anode of the LED display panel 10, and a second end of the other of the switching circuit 31 and the driving circuit 33 is connected with a cathode of the LED display panel 10; the control circuit 35 includes: a power supply control circuit 351 and a driving control 353, wherein the power supply control circuit 351 is connected with a third end of the switching circuit 31 through a power supply control port, and is configured to control the switching-on or switching-off of the switching circuit 31; the driving control circuit 353 is connected with a third end of the driving circuit 33 through a driving control port, and is configured to control the switching-on or switching-off of the driving circuit 33. Wherein, the switching circuit 31 is configured to control the power supply of the LED display panel 10, and the driving circuit 33 is configured to control the ordered display of the LED display panel 10.

The switching circuit 31, the driving circuit 33 and the control circuit 35 are integrated in the display driving circuit 30, and then more display driving circuits 30 can be placed under the condition of not changing the area of the LED display panel 10, so that the number ratio of the LED particles to the display driving circuits 30 on the LED display with a fixed area is reduced, and the refresh rate is increased; and the connection relationship between the LED particle array with M lines and N columns in the LED display panel 10 and the display driving circuits 30 is clearer, and fewer connection lines are required, so that the design difficulty of a PCB is lowered. The problems of large PCB area occupied by the control circuit 35 and low refresh rate of the LED display in related art are solved, and the effects of small PCB area occupied by the control circuit 35, simple design and high refresh rate of the LED display are achieved.

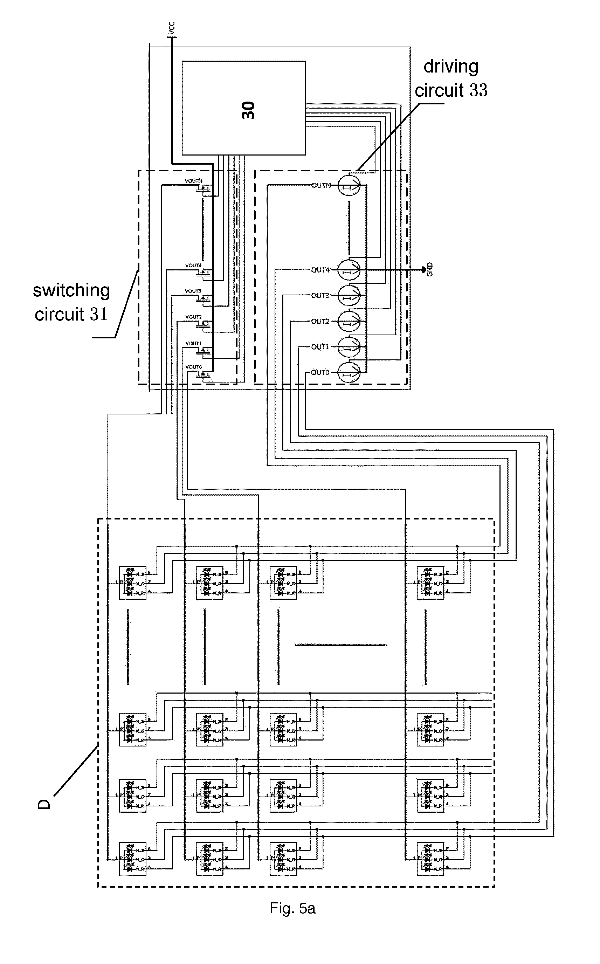

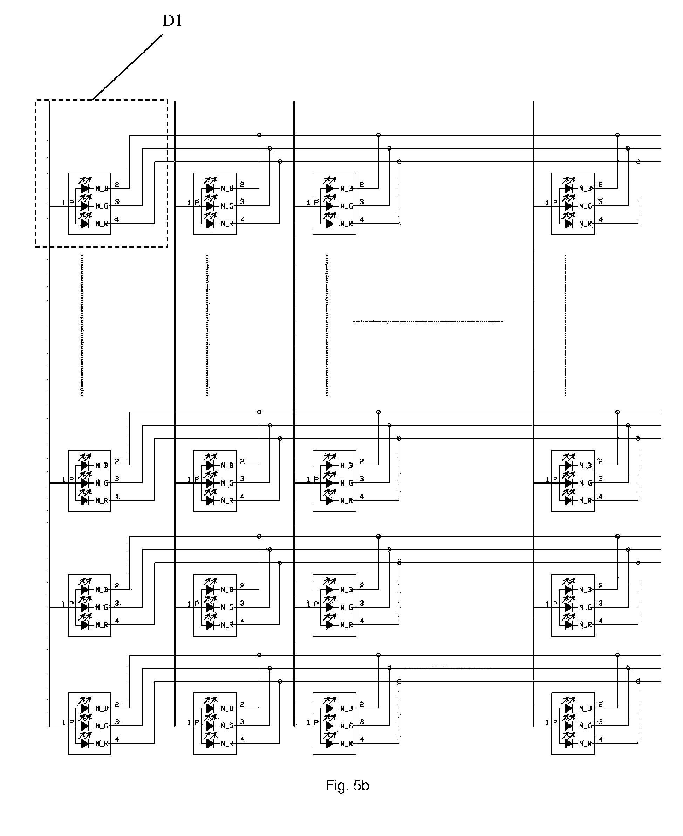

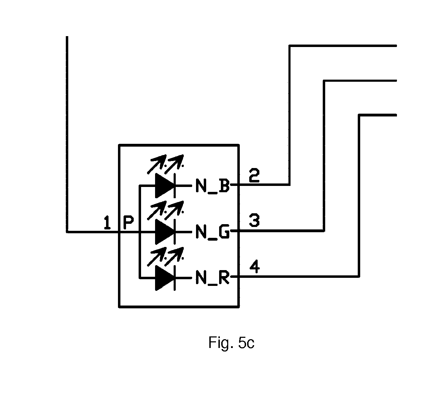

Fig. 5 is a structure diagram of an LED display according to a preferred embodiment of the invention; Fig. 5a is a detailed structure diagram of the LED display according to the preferred embodiment of the invention shown in Fig. 5; Fig. 5b is a drawing of partial enlargement of a dotted part D in Fig. 5a; and Fig. 5c is a drawing of partial enlargement of a dotted part D1 in Fig. 5b.

As shown in Fig. 5, the display driving circuit in the display can also include: the switching circuit 31, wherein the first end of the switching circuit 31 is connected to the grounding end of the power supply equipment, and the second end of the switching circuit 31 is connected with the anode of the LED display panel; the control circuit in the display can also include: the power supply control circuit, wherein the power supply control circuit is connected with the third end of the switching circuit through the power supply control port, and is configured to control the switching-on or switching-off of the switching circuit 31; wherein the switching circuit 31 is configured to control the power supply of the LED display panel.

As shown in Fig. 5a, Fig. 5b and Fig. 5c, the switching circuit 31 can include a switching sub-circuit, and the switching sub-circuit includes one or more field effect transistors, wherein a source of each field effect transistor is connected with the power end or the grounding end of the power supply equipment; a drain of each field effect transistor is connected with an anode or cathode of each LED particle in the corresponding line in the LED display panel 10; and a gate of each field effect transistor is connected with a corresponding connection terminal in the power supply control port.

According to the above embodiment of the invention, the driving circuit 33 can include a constant current channel group, and the constant current channel group includes one or more constant current logic components, wherein a first end of each constant current logic component is connected with the power end or grounding end of the power supply equipment; a second end of each constant current logic component is connected with the anodes or cathodes of the LED particles in a corresponding column in the LED display panel 10; and a third end of each constant current logic component is connected with the corresponding connection terminal in the driving control port.

Specifically, the power supply control circuit 351 is configured to control each field effect transistor to be switched on to supply power to the LED particles in the line corresponding to the field effect transistor in the LED display panel 10; and the driving control circuit 353 is configured to control each constant current logic component in the constant current channel group to be switched on, and each constant current logic component provides a current path for the LED particles in the column corresponding to the constant current logic component in the LED display panel 10 to control the ordered display of the LED particles after being switched on.

Specifically, the field effect transistors can be P-MOS transistors, the LED display panel 10 includes M lines and N columns of LED particles, and each LED particle respectively includes an red lamp tube, a green lamp tube and a blue lamp tube, wherein the anode of the red lamp tube, the anode of the green lamp tube and the anode of the blue lamp tube in an ith LED particle in each line are connected in parallel with an ith joint, and each joint in each line is connected in parallel, and is respectively connected with the drain of the corresponding P-MOS transistor in the switching circuit 31; the cathode of the red lamp tube of each LED particle in each column is connected in parallel with each other, and is respectively connected with the second end of a corresponding constant current logic component in the constant current channel group; the cathode of the green lamp tube of each LED particle in each column is connected in parallel with each other, and is respectively connected with the second end of a corresponding constant current logic component in the constant current channel group; and the cathode of the blue lamp tube of each LED particle in each column is connected in parallel with each other, and is respectively connected with the second end of a corresponding constant current logic component in the constant current channel group. Wherein, i is more than or equal to 1 and less than or equal to N, and is a natural number, and the red lamp tubes, the green lamp tubes and the blue lamp tubes can be R/G/B LEDs respectively.

Wherein, in the embodiment of the invention, Fig. 5b is a drawing of partial enlargement of a part D covered by a dotted line in Fig. 5a, the LED particle shown in Fig. 5c is a drawing of partial enlargement of a part D1 covered by a dotted line in Fig. 5b, and in Fig. 5c, pin 1 is a common anode, and pins 2/3/4 are cathodes of the B/G/R LEDs respectively.

The display driving circuit 30 includes a switching sub-circuit, the constant current channel group and the control circuit 35. The switching sub-circuit 31 includes N P-MOS transistors, wherein the drain of each P-MOS transistor serves as one of output pins of the control circuit 35, the source of each P-MOS transistor is connected to a power supply end (i.e. VCC end) of the display driving circuit 30, and the gate of each P-MOS transistor is connected with a connection terminal in the power supply control port of the control circuit 35; the constant current channel group can include N constant current logic components (which can also be called constant current logic circuits), the second end (input end of the constant current logic component in the embodiment) of each constant current logic component serves as one of input pins of the display driving circuit 30, the first ends (i.e. output ends) of all the constant current logic components are internally interconnected, and are connected with the grounding end of the power supply equipment as a grounding end (i.e. GND end) of the display driving circuit 30, and the third ends (control ends of the constant current logic components in the embodiment) of the constant current logic components are connected with the driving control port of the control circuit 35, and are configured to receive a constant current control signal of the driving circuit 33.

In embodiment 1, the LED display panel 10 (which can be called an LED unit as well as an LED unit board) includes a matrix with M lines and N columns of LED particles, wherein the anodes of the LED particles in each line are interconnected to the ith joint, each joint is connected to the output pin corresponding to the drain of the corresponding P-MOS transistor in the switching sub-circuit 31 in the switching circuit 31 and the cathodes of the LEDs in the same primary colors in the LED particles in each column are interconnected to the input ends of the corresponding constant current logic components of the constant current channel group of the display driving circuit 30, that is, the common cathode of the red lamp tubes (i.e. R LEDs) in the LED particles in each column is interconnected to the input end of the corresponding constant current logic component of the constant current channel group of the display driving circuit 30; the common cathode of the green lamp tubes (i.e. G LEDs) in the LED particles in each column is interconnected to the input end of the corresponding constant current logic component of the constant current channel group of the display driving circuit 30; and the common cathode of the blue lamp tubes (i.e. B LEDs) in the LED particles in each column is interconnected to the input end of the corresponding constant current logic component of the constant current channel group of the display driving circuit 30.

According to the LED display panel 10, under the control of the display driving circuit 30, the power supply control circuit 351 controls a certain P-MOS transistor in the switching sub-circuit 31 (which can be the P-MOS channel group) to be in an on state through the power supply control port to supply power to the anodes of the LED particles in the corresponding line on the LED display panel 10, and the driving control circuit 353 outputs a constant current control signal to each constant current logic component in the constant current channel group through the driving control port to control each constant current logic component to be in an on working state, thereby providing the current paths for the cathodes of the LED particles in the corresponding columns and realizing the ordered display of the LED unit. Wherein, the cathodes of the LED particles in the corresponding columns include the cathodes of the R, G and B three primary colors lamp tubes, that is, the ordered display of the red lamp tubes, the green lamp tubes and the blue lamp tubes of the LED particles in the corresponding columns respectively.

In the embodiment of the invention, the field effect transistors can be P-MOS transistors, the LED display panel 10 includes M lines and N columns of LED particles, and each LED particle includes an red lamp tube, a green lamp tube and a blue lamp tube, wherein the anode of the red lamp tube, the anode of the green lamp tube and the anode of the blue lamp tube in each LED particle in each line are connected in parallel, and are connected with the drain of the corresponding P-MOS transistor in the switching circuit 31; the cathode of the red lamp tube of each LED particle in each column is connected in parallel, and is connected with the second end of the corresponding constant current logic component in the constant current channel group; the cathode of the green lamp tube of each LED particle in each column is connected in parallel, and is connected with the second end of the corresponding constant current logic component in the constant current channel group; and the cathode of the blue lamp tube of each LED particle in each column is connected in parallel, and is connected with the second end of the corresponding constant current logic component in the constant current channel group.

Based on the technical solution shown in embodiment 1, there can be a first transformed implementation mode as follows:
the anodes of the R/G/B LEDs of the LED particles in each line in the LED display panel 10 are interconnected to the output pin corresponding to the drain of a corresponding P-MOS transistor in the switching circuit 31 in the display driving circuit 30, and the cathodes of the LEDs in the same primary colors in the LED particles in each column are interconnected to the input ends of the constant current logic components of the constant current channel group of the display driving circuit 30, that is, the common cathode of the R LEDs in the LED particles in each column is interconnected to the input end of the constant current logic component of the constant current channel group of the display driving circuit 30; the common cathode of the G LEDs in the LED particles in each column is interconnected to the input end of the constant current logic component of the constant current channel group of the display driving circuit 30; and the common cathode of the B LEDs in the LED particles in each column is interconnected to the input end of the constant current logic component of the constant current channel group of the display driving circuit 30.

In the transformed mode, a connection relationship of the anodes of the LED particles in each line in the LED display panel 10 rather than a control mode of the display driving circuit 30 is changed, and in the transformed mode, the anodes of the R/G/B LEDs of the LED particles in each line are directly interconnected, and are connected to the output pin corresponding to the drain of a corresponding P-MOS transistor in the switching circuit. In the transformed mode, the switching circuit 31, the driving circuit 33 and the control circuit 35 are integrated in the display driving circuit 30, and then more display driving circuits 30 can be placed under the condition of not changing the area of the LED display panel 10, so that the number ratio of the LED particles and the display driving circuits 30 on the LED display with the fixed area is reduced, and the refresh rate is increased; moreover, the connection relationship between the LED particle array in the LED display panel 10 and the display driving circuits 30 is clearer, and fewer connection lines are required, so that the design difficulty of the PCB is lowered.

Based on the technical solution shown in embodiment 1, there can also be a second transformed implementation mode as follows:
the field effect transistors can also be N-channel Metal Oxide Semiconductor (N-MOS) transistors, the LED display panel 10 can include M lines and N columns of LED particles, and each LED particle includes an red lamp tube, a green lamp tube and a blue lamp tube, wherein the cathode of the red lamp tube, the cathode of the green lamp tube and the cathode of the blue lamp tube in the ith LED particle in each line are connected in parallel with the ith joint, and each joint in each line is connected in parallel, and is connected with a drain of the corresponding N-MOS transistor in the switching circuit 31; the anode of the red lamp tube in each LED particle in each column is connected in parallel, and is connected with the second end of the corresponding constant current logic component in the constant current channel group; the anode of the green lamp tube of each LED particle in each column is connected in parallel, and is connected with the second end of the corresponding constant current logic component in the constant current channel group; and the anode of the blue lamp tube of each LED particle in each column is connected in parallel, and is connected with the second end of the corresponding constant current logic component in the constant current channel group. Wherein, i is more than or equal to 1 and less than or equal to N, and is a natural number.

Specifically, in the second transformed mode, the switching sub-circuit includes N N-MOS transistors, wherein the drain of each N-MOS transistor serves as one of output pins of the control circuit 35, the source of each N-MOS transistor is connected with the grounding end of the power supply equipment as the grounding end (i.e. GND end) of the display driving circuit 30, and the gate of each N-MOS transistor is connected with a connection terminal in the power supply control port of the control circuit 35; the constant current channel group includes N constant current logic components (which can also be called constant current logic circuits), the second end (i.e. input end) of each constant current logic component serves as one of the input pins of the display driving circuit 30, the first ends (i.e. output ends) of all the constant current logic components are internally interconnected, and are connected with the grounding end of the power supply equipment as the power supply end (i.e. VCC end) of the display driving circuit 30, and the third ends (i.e. control ends) of the constant current logic components are connected with the display control port of the control circuit 35, and are configured to receive the constant current control signal of the driving circuit 33.

In the second transformed mode, the LED display panel 10 (which can also be called an LED unit) includes a matrix with M lines and N columns of LED particles, wherein the cathodes of the LED particles in each line are interconnected to the ith joint, each joint is connected to the output pin corresponding to the drain of the corresponding N-MOS transistor in the switching circuit 31 in the display driving circuit 30, and the anodes of the LEDs in the same primary colors in the LED particles in each column are interconnected to the input ends of the corresponding constant current logic components of the constant current channel group of the display driving circuit 30, that is, the common anode of the R LEDs in the LED particles in each column is interconnected to the input end of the corresponding constant current logic component of the constant current channel group of the display driving circuit 30; the common anode of the G LEDs in the LED particles in each column is interconnected to the input end of the corresponding constant current logic component of the constant current channel group of the display driving circuit 30; and the common anode of the B LEDs in the LED particles in each column is interconnected to the input end of the corresponding constant current logic component of the constant current channel group of the display driving circuit 30.

In the second transformed mode, the power supply control circuit 351 in the display driving circuit 30 controls any one N-MOS transistor in the switching circuit 31 to be in an on state through the power supply control port to supply power to the anodes of the LED particles in the corresponding line on the LED display panel 10, and the driving control circuit 353 outputs the constant current control signal to each constant current logic component in the constant current channel group through the driving control port to control each constant current logic component to be in an on working state, thereby providing the current path for the anodes of the LED particles in the corresponding columns and realizing the ordered display of the LED unit. Wherein, the anodes of the lamp tubes of the LED particles in the corresponding columns include the anodes of three primary colors R, G and B, that is, the ordered display of the red lamp tubes, the green lamp tubes and the blue lamp tubes of the LED particles in the corresponding columns is also controlled respectively.

Based on the technical solution shown in the second transformed mode of embodiment 1, there can also be a transformed implementation mode as follows:
the field effect transistors can be N-MOS transistors, the LED display panel 10 can include M lines and N columns of LED particles, and each LED particle includes an red lamp tube, a green lamp tube and a blue lamp tube, wherein the cathode of the red lamp tube, the cathode of the green lamp tube and the cathode of the blue lamp tube in each LED particle in each line are connected in parallel, and are connected with the drain of the corresponding N-MOS transistor in the switching circuit 31; the anode of the red lamp tube of each LED particle in each column is connected in parallel, and is connected with the second end of the corresponding constant current logic component in the constant current channel group; the anode of the green lamp tube of each LED particle in each column is connected in parallel, and is connected with the second end of the corresponding constant current logic component in the constant current channel group; and the anode of the blue lamp tube of each LED particle in each column is connected in parallel, and is connected with the second end of the corresponding constant current logic component in the constant current channel group.

Specifically, the cathodes of the LED particles in each line in the LED display panel 10 in the implementation mode can be interconnected to the output pin corresponding to the drain of the corresponding N-MOS transistor in the switching circuit 31 in the display driving circuit 30, and the anodes of the LEDs in the same primary colors in the LED particles in each column are interconnected to the input ends of the corresponding constant current logic components of the constant current channel group of the display driving circuit 30, that is, the common anode of the R LEDs of red lamp tubes in the LED particles in each column is interconnected to the input end of the corresponding constant current logic component of the constant current channel group of the display driving circuit 30; the common anode of the G LEDs in the LED particles in each column is interconnected to the input end of the corresponding constant current logic component of the constant current channel group of the display driving circuit 30; and the common anode of the B LEDs in the LED particles in each column is interconnected to the input end of the corresponding constant current logic component of the constant current channel group of the display driving circuit 30.

Based on the technical solution shown in embodiment 1, there can also be a third transformed implementation mode as follows:
in the implementation mode, the driving circuit 33 can include a first constant current channel group, a second constant current channel group and a third constant current channel group, wherein the first constant current channel group includes one or more constant current logic components, a first end of each constant current logic component is connected with the power end or grounding end of the power supply equipment, a third end of each constant current logic component is connected with a first R display control sub-port of the driving control port, and a second end of each constant current logic component is connected with the anode or cathode of the red lamp tube in each LED particle in the corresponding column in the LED display panel 10, and is configured to control the display of the red lamp tubes of the LED display panel 10; the second constant current channel group includes one or more constant current logic components, a first end of each constant current logic component is connected with the power end or grounding end of the power supply equipment, a third end of each constant current logic component is connected with a first G display control sub-port of the driving control port, and a second end of each constant current logic component is connected with the anode or cathode of the green lamp tube in each LED particle in the corresponding column in the LED display panel 10, and is configured to control the display of the green lamp tubes of the LED display panel 10; and the third constant current channel group includes one or more constant current logic components, a first end of each constant current logic component is connected with the power end or grounding end of the power supply equipment, a third end of each constant current logic component is connected with a first B display control sub-port of the driving control port, and a second end of each constant current logic component is connected with the anode or cathode of the blue lamp tube in each LED particle in the corresponding column in the LED display panel 10, and is configured to control the display of the blue lamp tubes of the LED display panel 10. Wherein, the first constant current channel group can be an R constant current channel group, the second constant current channel group can be a G constant current channel group, and the third constant current channel group can be a B constant current channel group.

Specifically, the R constant current channel group can include one or more constant current logic components, the second ends (i.e. input ends) of these constant current logic components are connected to the cathodes (i.e. R cathodes) of the red lamp tubes of the LED particles in the corresponding columns in the LED display panel 10, the first ends (i.e. output ends) of the constant current logic components are interconnected as an external pin GND of the display driving circuit 30, and are connected to the grounding end of the power supply equipment, and the third ends (i.e. control ends) of the constant current logic components are connected to the first R display control sub-port of the driving control port to receive an R display control signal of the driving control circuit 353; the G constant current channel group can include one or more constant current logic components, the second ends (i.e. input ends) of these constant current logic components are connected to the cathodes (i.e. G cathodes) of the green lamp tubes of the LED particles in the corresponding columns in the LED display panel 10, the first ends (i.e. output ends) of the constant current logic components are interconnected as the external pin GND of the display driving circuit 30, and are connected to the grounding end of the power supply equipment, and the third ends (i.e. control ends) of the constant current logic components are connected to the first G display control sub-port of the driving control port to receive a G display control signal of the driving control circuit 353; and the B constant current channel group can include one or more constant current logic components, the second ends (i.e. input ends) of these constant current logic components are connected to the cathodes (i.e. B cathodes) of the blue lamp tubes of the LED particles in the corresponding columns in the LED display panel 10, the first ends (i.e. output ends) of the constant current logic components are interconnected as the external pin GND of the display driving circuit 30, and are connected to the grounding end of the power supply equipment, and the third ends (i.e. control ends) of the constant current logic components are connected to the first B display control sub-port of the driving control port to receive a B display control signal of the driving control circuit 353.

In the implementation mode, the power supply control circuit 351 controls each field effect transistor to be switched on to supply power to the LED particles in the lines corresponding to the field effect transistors in the LED display panel 10; the driving control circuit 353 is configured to control each constant current logic component in the first constant current channel group to be switched on through the first R display control sub-port, and each constant current logic component provides a current path for the red lamp tubes in the LED particles in the column corresponding to the constant current logic component in the LED display panel 10 to control the display of the red lamp tubes of the LED particles in the line corresponding to the field effect transistor in the LED display panel 10 after being switched on; the driving control circuit 353 is further configured to control each constant current logic component in the second constant current channel group to be switched on through the first G display control sub-port, and each constant current logic component provides a current path for the green lamp tubes in the LED particles in the column corresponding to the constant current logic component in the LED display panel 10 to control the display of the green lamp tubes of the LED particles in the line corresponding to the field effect transistor in the LED display panel 10 after being switched on; and the driving control circuit 353 is further configured to control each constant current logic component in the third constant current channel group to be switched on through the first B display control sub-port, and each constant current logic component provides a current path for the blue lamp tubes in the LED particles in the column corresponding to the constant current logic component in the LED display panel 10 to control the display of the blue lamp tubes of the LED particles in the line corresponding to the field effect transistor in the LED display panel 10 after being switched on.

In the implementation mode, the power supply control port of the display driving circuit 30 is unchanged, and the driving control port includes three control sub-ports for controlling the switching-on or switching-off of the first/second/third constant current channel groups to enable the switching circuit and the driving circuit to control the power supply of the LED particles in each line and the ordered display of the LED particles in each column in the LED display panel respectively. In the transformed mode, the switching circuit 31, the driving circuit 33 and the control circuit 35 are integrated in the display driving circuit 30, only the driving circuit includes the three constant current channel groups, and more display driving circuits 30 can still be placed under the condition of not changing the area of the LED display panel 10, so that the number ratio of the LED particles and the display driving circuits 30 on the LED display with the fixed area is reduced, and the refresh rate is increased; moreover, the connection relationship between the LED particle array in the LED display panel 10 and the display driving circuits 30 is clearer, and fewer connection lines are required, so that the design difficulty of the PCB is lowered.

In the implementation mode, the field effect transistors can be P-MOS transistors, the LED display panel 10 includes M lines and N columns of LED particles, and each LED particle includes an red lamp tube, a green lamp tube and a blue lamp tube, wherein the anode of the red lamp tube, the anode of the green lamp tube and the anode of the blue lamp tube in the ith LED particle in each line are connected in parallel to the ith joint, and each joint in each line is connected in parallel, and is connected with the drain of the corresponding P-MOS transistor in the switching circuit 31; the cathode of the red lamp tube of each LED particle in each column is connected in parallel, and is connected with the second end of the corresponding constant current logic component in the first constant current channel group; the cathode of the green lamp tube of each LED particle in each column is connected in parallel, and is connected with the second end of the corresponding constant current logic component in the second constant current channel group; and the cathode of the blue lamp tube of each LED particle in each column is connected in parallel, and is connected with the second end of the corresponding constant current logic component in the third constant current channel group. Wherein, i is more than or equal to 1 and less than or equal to N, and is a natural number, and the red lamp tubes, the green lamp tubes and the blue lamp tubes can be the R/G/B LEDs respectively.

In addition, the LED display panel 10 (which can also be called an LED unit) includes a matrix with M lines and N columns of LED particles, wherein the anodes of the LED particles in each line are interconnected to the ith joint, each joint is connected to the output pin corresponding to the drain of the corresponding P-MOS transistor in the switching circuit 31 in the display driving circuit 30, and the cathodes of the LEDs in the same primary colors in the LED particles in each column are interconnected to the input ends of the corresponding constant current logic components of the first constant current channel group of the display driving circuit 30, that is, the common cathode of the R LEDs in the LED particles in each column is interconnected to the input end of the constant current logic component of the second constant current channel group of the display driving circuit 30; the common cathode of the G LEDs in the LED particles in each column is interconnected to the input end of the constant current logic component of the constant current channel group of the display driving circuit 30; and the common cathode of the B LEDs in the LED particles in each column is interconnected to the input end of the constant current logic component of the third constant current channel group of the display driving circuit 30.

In the embodiment, the power supply control circuit 351 of the display driving circuit 30 controls any one P-MOS transistor in the switching circuit 31 to be in an on state through the power supply control port to supply power to the anodes of the LED particles in the corresponding line on the LED display panel 10, and the driving control circuit 353 outputs an R display control signal/G display control signal/B display control signal to each constant current logic component in the first constant current channel group/second constant current channel group/third constant current channel group through the first R display control sub-port/first G display control sub-port/first B display control sub-port to control each constant current logic component in the three constant current channel groups to be in an on working state, thereby providing the current paths for the R cathodes, G cathodes and B cathodes of the LED particles in the corresponding columns and realizing the ordered display of the LED particles. Wherein, the R cathodes, G cathodes and B cathodes of the LED particles in the corresponding columns are the cathodes of the red lamp tubes, the green lamp tubes and the green lamp tubes of the LED particles in the corresponding columns respectively. Wherein, the switching sub-circuit can also be called a P-MOS channel.

Based on the technical solution shown in the third transformed implementation mode of embodiment 1, there can also be a transformed implementation mode as follows:
the field effect transistors can be P-MOS transistors, the LED display panel 10 can include M lines and N columns of LED particles, and each LED particle includes an red lamp tube, a green lamp tube and a blue lamp tube, wherein the anodes of the red lamp tube, the anodes of the green lamp tube and the anodes of the blue lamp tube in each LED particle in each line are connected in parallel, and are connected with the drain of the corresponding P-MOS transistor in the switching circuit 31; the cathode of the red lamp tube of each LED particle in each column is connected in parallel, and is connected with the second end of the corresponding constant current logic component in the first constant current channel group; the cathode of the green lamp tube of each LED particle in each column is connected in parallel, and is connected with the second end of the corresponding constant current logic component in the second constant current channel group; and the cathode of the blue lamp tube of each LED particle in each column is connected in parallel, and is connected with the second end of the corresponding constant current logic component in the third constant current channel group.

Specifically, the anodes of the LED particles in each line in the LED display panel 10 are interconnected to the output pin corresponding to the drain of a corresponding P-MOS transistor in the switching circuit 31 in the display driving circuit 30, and the cathodes of the LEDs in the same primary colors in the LED particles in each column are interconnected to the input ends of the constant current logic components of the first constant current channel group of the display driving circuit 30, that is, the common cathode of the R LEDs in the LED particles in each column is interconnected to the input end of the constant current logic component of the second constant current channel group of the display driving circuit 30; the common cathode of the G LEDs in the LED particles in each column is interconnected to the input end of the constant current logic component of the constant current channel group of the display driving circuit 30; and the common cathode of the B LEDs in the LED particles in each column is interconnected to the input end of the constant current logic component of the third constant current channel group of the display driving circuit 30.

In the implementation mode, the control mode is the same as that of the display driving circuit 30 in the technical solution shown in the third transformed implementation mode of embodiment 1, and similarly, the power supply control circuit 351 controls a certain P-MOS transistor in the switching circuit 31 (i.e. the P-MOS channel group) to be in an on state through the power supply control port to supply power to the anodes of the LED particles in the corresponding line on the LED display panel 10, and the driving control circuit 353 outputs the R display control signal/G display control signal/B display control signal to each constant current logic component in the first constant current channel group/second constant current channel group/third constant current channel group through the first R display control sub-port/first G display control sub-port/first B display control sub-port to control each constant current logic component in the three constant current channel groups to be in an on working state, thereby providing the current paths for the R cathodes, G cathodes and B cathodes of the LED particles in the corresponding columns and realizing the ordered display of the LED particles. Wherein, the R cathodes, G cathodes and B cathodes of the LED particles in the corresponding columns are the cathodes of the red lamp tubes, the green lamp tubes and the blue lamp tubes of the LED particles in the corresponding columns respectively.

### Embodiment 2:

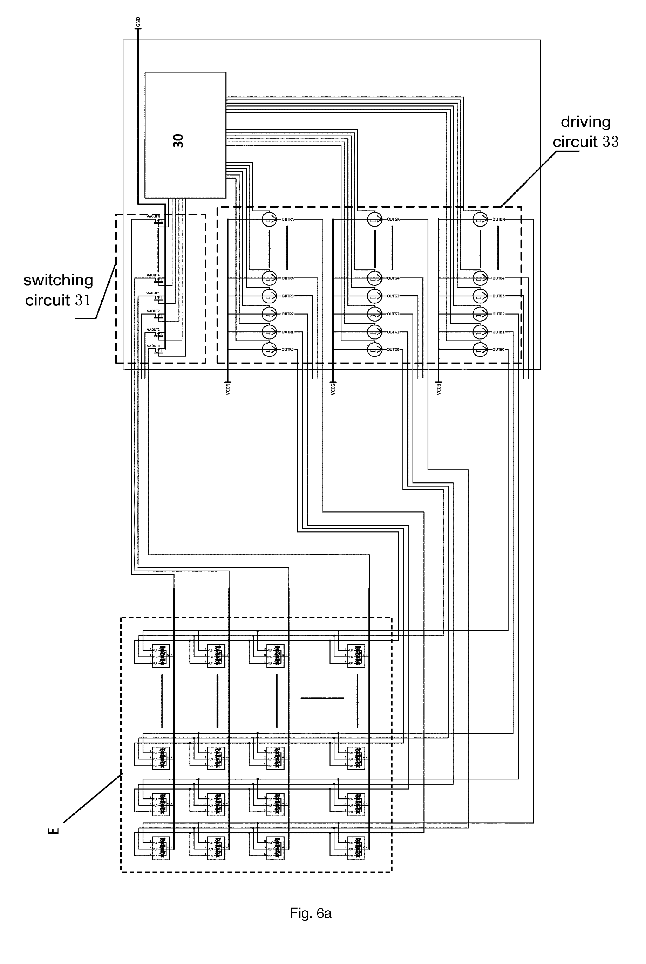

Fig. 6a to Fig. 6c are structure diagrams of an LED display according to embodiment 2 of the invention. As shown in Fig. 6a, field effect transistors in the LED display can also be N-MOS transistors, an LED display panel 10 can include M lines and N columns of LED particles, and each LED particle includes an red lamp tube, a green lamp tube and a blue lamp tube, wherein a cathode of the red lamp tube, a cathode of the green lamp tube and a cathode of the blue lamp tube in an ith LED particle in each line are connected in parallel with an ith joint, and each joint in each line is connected in parallel, and is connected with a drain of a corresponding N-MOS transistor in a switching circuit 31 respectively; an anode of the red lamp tube in each LED particle in each column is connected in parallel respectively, and is connected with the second end of a corresponding constant current logic component in the first constant current channel group respectively as a connection terminal of an anode of the LED display panel 10; an anode of the green lamp tube of each LED particle in each column is connected in parallel respectively, and is connected with the second end of a corresponding constant current logic component in the second constant current channel group respectively as a connection terminal of the anode of the LED display panel 10; and an anode of the blue lamp tube of each LED particle in each column is connected in parallel respectively, and is connected with the second end of a corresponding constant current logic component in the third constant current channel group respectively as a connection terminal of the anode of the LED display panel 10.

Specifically, as shown in Fig. 6a, the R constant current channel group can include one or more constant current logic components, first ends (input ends in the embodiment) of these constant current logic components are interconnected as an external pin VCCR of the display driving circuit 30, and are connected to a power end of a power supply equipment, second ends (i.e. output ends) of the constant current logic components are connected to the anodes (R anodes in the embodiment) of the red lamp tubes of the LED particles in the corresponding columns in the LED display panel 10, and third ends (i.e. control ends) of the constant current logic components are connected to a first R display control port; the G constant current channel group can include one or more constant current logic components, first ends (input ends in the embodiment) of these constant current logic components are interconnected as an external pin VCCG of the display driving circuit 30, and are connected to a power end of the power supply equipment, second ends (i.e. output ends) of the constant current logic components are connected to the anodes (G anodes in the embodiment) of the green lamp tubes of the LED particles in the corresponding columns in the LED display panel 10, and third ends (i.e. control ends) of the constant current logic components are connected to a first G display control port; and the B constant current channel group can include one or more constant current logic components, first ends (input ends in the embodiment) of the constant current logic components are interconnected as an external pin VCCB of the display driving circuit 30, and are connected to the power end of the power supply equipment, second ends (i.e. output ends) of the constant current logic components are connected to the anodes (B anodes in the embodiment) of the blue lamp tubes of the LED particles in the corresponding columns in the LED display panel 10, and third ends (i.e. control ends) of the constant current logic components are connected to a first B display control port.

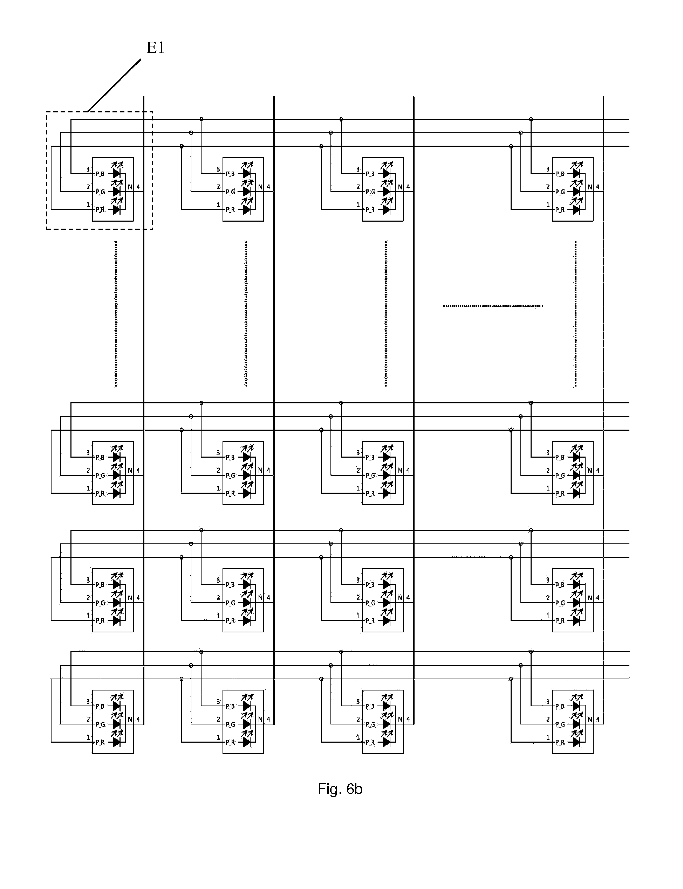

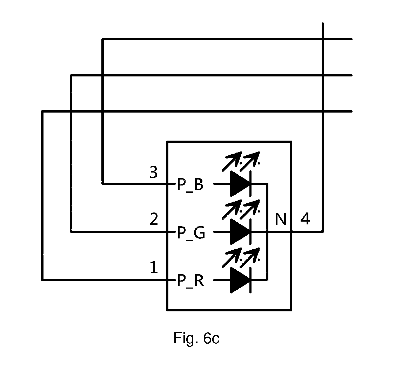

The LED particle shown in Fig. 6c is a drawing of partial enlargement of a part E1 covered by a dotted line in Fig. 6b, wherein pin 4 is a common cathode, and pins 2/3/4 are the anodes of R/G/B LEDs respectively.

Wherein, in the embodiment, a power supply voltage of the external pin VCCR of the display driving circuit 30 can be lower than that of the external pin VCCR/VCCB, and specifically, the power supply voltage of the VCCR can be 1.6V which is obtained by subtracting a working voltage (1.8-2V) of the red lamp tubes from a working voltages (3.4-3.6V) of the green and blue lamp tubes, and the power supply voltages of the R/G/B LEDs are differentially controlled, thereby reducing the power consumption of the LED display.

In embodiment 2, the LED display panel 10 (which can also be called an LED unit) includes a matrix with M lines and N columns of LED particles, wherein the cathodes of the LED particles in each line are interconnected to the ith joint, each joint is connected to an output pin corresponding to the drain of the corresponding N-MOS transistor in the switching circuit 31 in the display driving circuit 30, and the anodes of the LEDs in the same primary colors in the LED particles in each column are interconnected to the input ends of the corresponding constant current logic components of the constant current channel group of the display driving circuit 30, that is, the common anode of the R LEDs in the LED particles in each column is interconnected to the input end of the corresponding constant current logic component of the second constant current channel group of the display driving circuit 30; the common anode of the G LEDs in the LED particles in each column is interconnected to the input end of the corresponding constant current logic component of the constant current channel group of the display driving circuit 30; and the common anode of the B LEDs in the LED particles in each column is interconnected to the input end of the corresponding constant current logic component of the third constant current channel group of the display driving circuit 30. Under the control of the display driving circuit 30, the power supply control circuit 351 controls a certain N-MOS transistor in the switching sub-circuit 31 (which can be an N-MOS channel group) to be in an on state through a power supply control port to supply power to the anodes of the LED particles in the corresponding line on the LED display panel 10, and the driving control circuit 353 outputs an R display control signal/G display control signal/B display control signal to each constant current logic component in the first constant current channel group/second constant current channel group/third constant current channel group through the first R display control sub-port/first G display control sub-port/first B display control sub-port to control each constant current logic component in the three constant current channel groups to be in an on working state respectively, thereby providing the current paths for the R anodes, G anodes and B anodes of the LED particles in the corresponding columns and realizing the ordered display of the LED particles. Wherein, the R anodes, G anodes and B anodes of the LED particles in the corresponding columns are the anodes of the red lamp tubes, the green lamp tubes and the blue lamp tubes of the LED particles in the corresponding columns respectively.

### Embodiments 3 and 4:

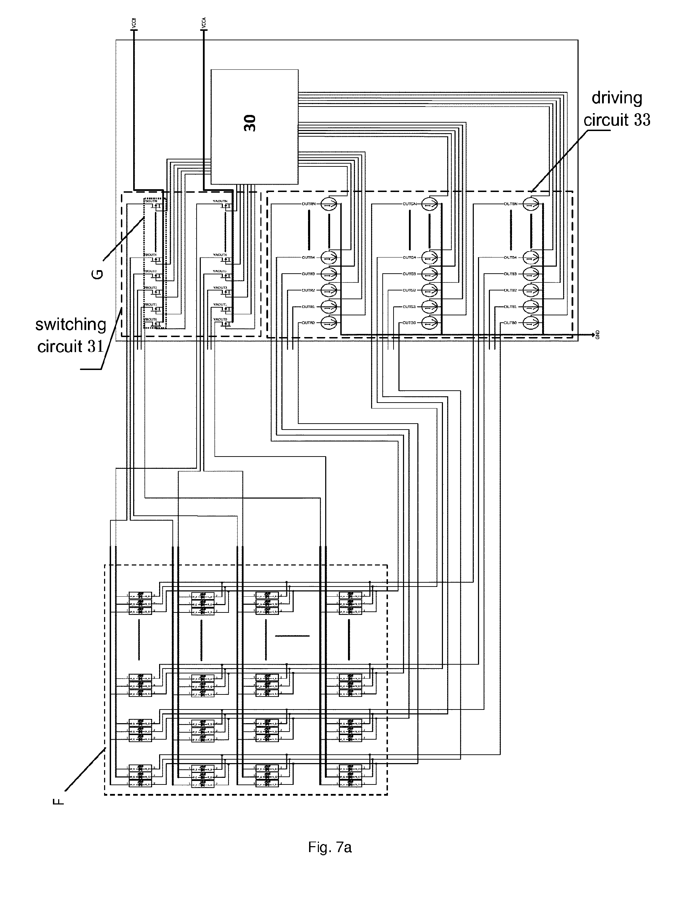

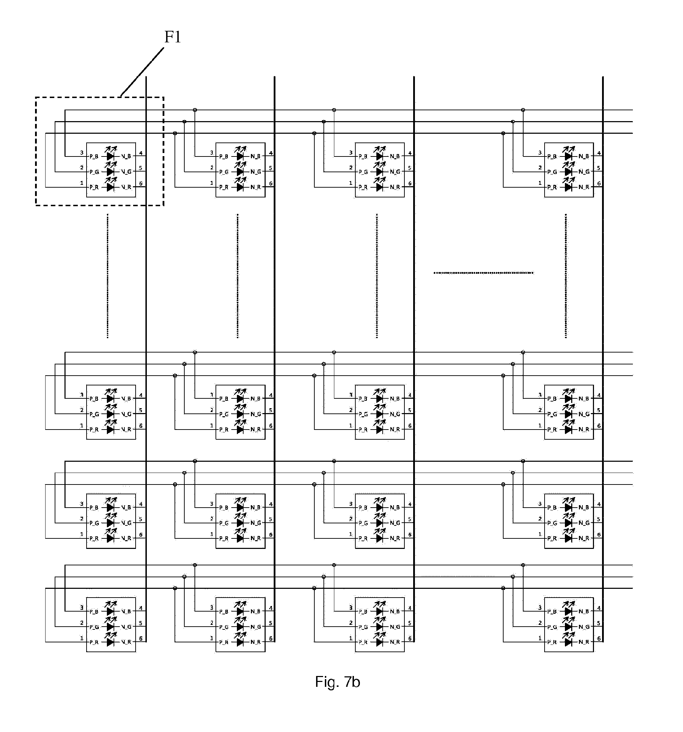

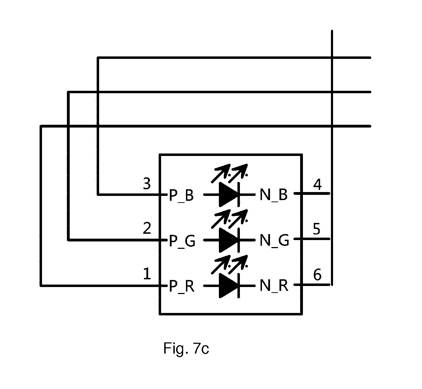

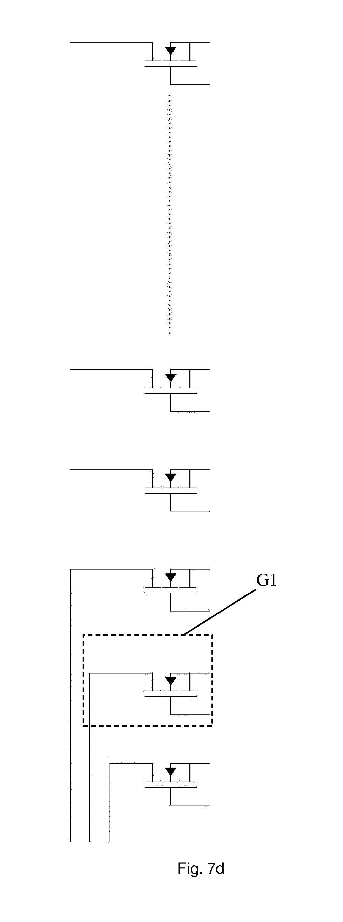

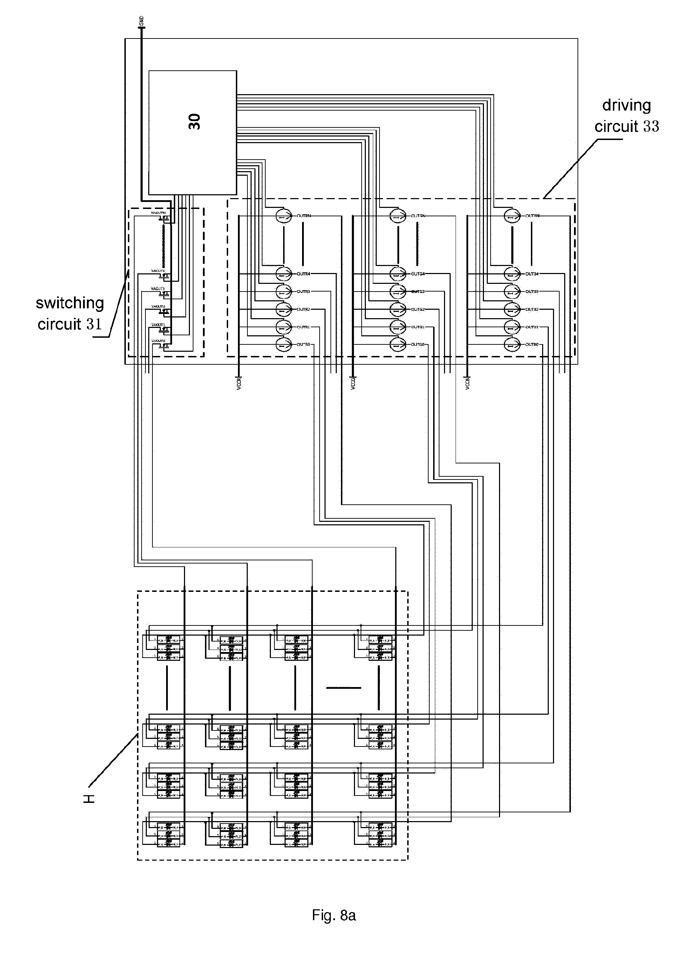

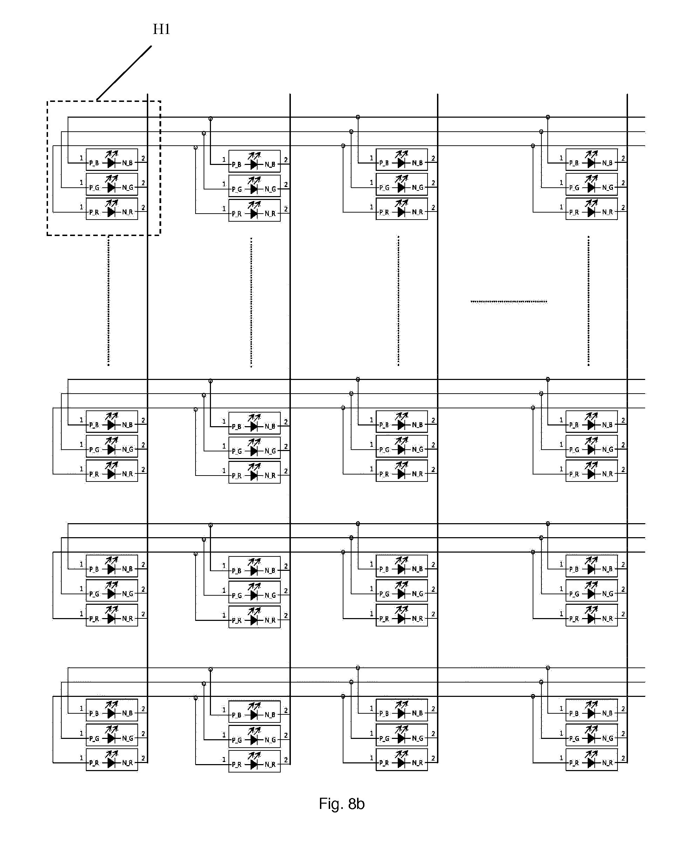

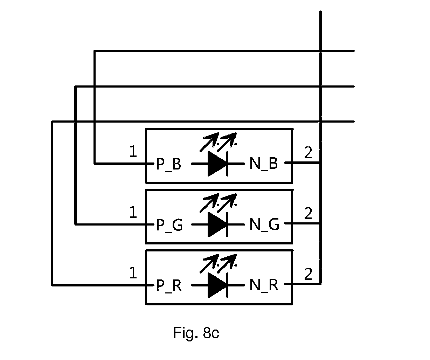

Fig. 7a to Fig. 7e are structure diagrams of an LED display according to embodiment 3 of the invention; and Fig. 8a to Fig. 8c are structure diagrams of an LED display according to embodiment 4 of the invention. Fig. 7b and Fig. 8b show drawings of partial enlargement of a part F covered by a dotted line in Fig. 7a and a part H covered by a dotted line in Fig. 8a in the two embodiments respectively, LEDs of three primary colors in an LED particle in Fig. 7c are directly integrated on the LED particle, LEDs in three primary colors in an LED particle in Fig. 8c are encapsulated and integrated on the LED particle respectively, but beyond that, the same circuit connection relationship can be adopted in the two implementation modes. Wherein, an anode of each LED particle in Fig. 7c has three pins, i.e. 1, 2 and 3 respectively, corresponding to anodes of internal R/G/B LEDs respectively, and a cathode of each LED particle in Fig. 7c has three pins, i.e. 4, 5 and 6 respectively, corresponding to cathodes of the internal B/G/R LEDs respectively; and as shown in Fig. 8c, the anodes of the R/G/B LEDs are pins 1, the cathodes of the R/G/B LEDs are pins 2, and the R/G/B LEDs are welded in parallel as the LED particles (i.e. full-color pixels).

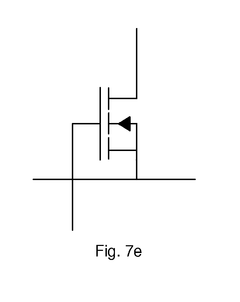

Specifically, as shown in Fig. 7e and Fig. 8a, field effect transistors can also be N-MOS transistors, an LED display panel 10 can include M lines and N columns of LED particles, and each LED particle includes an red lamp tube, a green lamp tube and a blue lamp tube respectively, wherein the cathode of the red lamp tube, the cathode of the green lamp tube and the cathode of the blue lamp tube in each LED particle in each line are connected in parallel, and are connected with the drain of a corresponding N-MOS transistor in a switching circuit 31 respectively; the anode of the red lamp tube in each LED particle in each column is connected in parallel respectively, and is connected with the second end of a corresponding constant current logic component in a first constant current channel group respectively; the anode of the green lamp tube of each LED particle in each column is connected in parallel respectively, and is connected with the second end of a corresponding constant current logic component in a second constant current channel group respectively; and the anode of the blue lamp tube of each LED particle in each column is connected in parallel respectively, and is connected with the second end of a corresponding constant current logic component in a third constant current channel group respectively.

In embodiments 3 and 4, the anodes of the LED particles in each line in the LED display panel 10 are interconnected to an output pin corresponding to the drain of the corresponding N-MOS transistor in the switching circuit 31 in the display driving circuit 30, the cathodes of the LED particles in each line are interconnected to an ith joint, each joint is connected to the output pin corresponding to the drain of the corresponding N-MOS transistor in the switching circuit 31 in the display driving circuit 30, and the anodes of the LEDs in the same primary colors in the LED particles in each column are interconnected to the input ends of the corresponding constant current logic components of the first constant current channel group of the display driving circuit 30, that is, the common anode of the R LEDs in the LED particles in each column is interconnected to the input end of the constant current logic component of the second constant current channel group of the display driving circuit 30; the common anode of the G LEDs in the LED particles in each column is interconnected to the input end of the constant current logic component of the constant current channel group of the display driving circuit 30; and the common cathode of the B LEDs in the LED particles in each column is interconnected to the input end of the constant current logic component of the third constant current channel group of the display driving circuit 30.

Based on the technical solutions shown in embodiments 3 and 4, there can also be a first transformed implementation mode as follows:
in the implementation mode, the switching circuit 31 includes a first switching sub-circuit and a second switching sub-circuit, each of the first switching sub-circuit and the second switching sub-circuit includes one or more field effect transistors, and a source of each field effect transistor in the first switching sub-circuit and the second switching sub-circuit is connected with a power end or grounding end of a power supply equipment respectively, wherein a drain of each field effect transistor in the first switching sub-circuit is connected with the anode or cathode of the red lamp tube in each LED particle in the corresponding line in the LED display panel respectively, and a gate of each field effect transistor is connected with a corresponding connection terminal in a power supply control port respectively, and is configured to control the power supply of the red lamp tubes of the LED display panel; and a drain of each field effect transistor in the second switching sub-circuit is connected with the anodes or cathodes of the green lamp tube and the blue lamp tube in each LED particle in the corresponding line in the LED display panel respectively, and a gate of each field effect transistor is connected with a corresponding connection terminal in the power supply control port respectively, and is configured to control the power supply of the green lamp tubes and the blue lamp tubes of the LED display panel.

In the implementation mode, the driving circuit 33 can include a constant current channel group, and the constant current channel group can include: one or more constant current logic components, wherein a first end of each constant current logic component is connected with the power end or grounding end of the power supply equipment; a second end of each constant current logic component is connected with the anodes or cathodes of the LED particles in the corresponding column in the LED display panel 10; and a third end of each constant current logic component is connected with the corresponding connection terminal in the driving control port.

In addition, in the embodiment, the power supply control circuit 351 is configured to control one field effect transistor in the first switching sub-circuit to be switched on to supply power to the red lamp tubes in the LED particles in the line corresponding to the field effect transistor in the first switching sub-circuit in the LED display panel 10; the power supply control circuit 351 is further configured to control the field effect transistor corresponding to the switched-on field effect transistor in the first switching sub-circuit in the second switching sub-circuit to be switched on to supply power to the green lamp tubes and the blue lamp tubes in the LED particles in the line corresponding to the field effect transistor in the first switching sub-circuit in the LED display panel 10; and the driving control circuit 353 is configured to control each constant current logic component in the constant current channel group to be switched on, and each constant current logic component provides a current path for the LED particles in the column corresponding to the constant current logic component in the LED display panel 10 to control the ordered display of the LED particles in the line corresponding to the field effect transistor in the LED display panel 10 respectively after being switched on.

The switching circuit 31, the driving circuit 33 and the control circuit 35 are integrated in the display driving circuit 30, and then more display driving circuits 30 can be placed under the condition of not changing the area of the LED display panel 10, so that the number ratio of the LED particles and the display driving circuits 30 on the LED display with the fixed area is reduced, and the refresh rate is increased.

The field effect transistors of the display driving circuit 30 in the embodiment can be P-MOS transistors, the LED display panel 10 can include M lines and N columns of LED particles, and each LED particle includes an red lamp tube, a green lamp tube and a blue lamp tube, wherein the anode of the red lamp tube in the ith LED particle in each line is connected in parallel with the ith joint, and each joint in each line is connected in parallel, and is connected with the drain of a corresponding P-MOS transistor in the first switching sub-circuit 31 respectively; the anodes of the green lamp tube and the anodes of the blue lamp tube in the jth LED particle in each line are connected in parallel with a jth joint, and each joint in each line is connected in parallel, and is connected with the drain of a corresponding P-MOS transistor in the second switching sub-circuit 31; the cathode of the red lamp tube of each LED particle in each column is connected in parallel, and is connected with the second end of a corresponding constant current logic component in the constant current channel group respectively; the cathode of the green lamp tube of each LED particle in each column is connected in parallel, and is connected with the second end of a corresponding constant current logic component in the constant current channel group respectively; and the cathode of the blue lamp tube of each LED particle in each column is connected in parallel, and is connected with the second end of a corresponding constant current logic component in the constant current channel group respectively. Wherein, i is more than or equal to 1 and less than or equal to N, j is more than or equal to 1 and less than or equal to N, both i and j are natural numbers, and the red lamp tubes, the green lamp tubes and the blue lamp tubes can be R/G/B LEDs respectively.

In the implementation mode, the display driving circuit 30 integrates the first switching sub-circuit and the second switching sub-circuit, and each of the two switching sub-circuits includes one or more P-MOS transistors respectively; the sources of each P-MOS transistor of the first switching sub-circuit is interconnected as an external pin VCCB of the display driving circuit 30, and is connected to a connection terminal of the power end of the power supply equipment, the gate of each P-MOS transistor is connected to an red power supply control signal of the power supply control port, and the drain of each P-MOS transistor is connected to the anodes (i.e. R anodes of the LED particles in the corresponding line) of the red lamp tubes of the LED particles in the corresponding line in the LED display panel 10; and the source of the P-MOS transistor of the second switching sub-circuit is interconnected as an external pin VCCA of the display driving circuit 30, and is connected to a connection terminal of the power end of the power supply equipment, the gate of the P-MOS transistor is connected to green and blue power supply control signals of the power supply control port, and the drain of the P-MOS transistor is connected to the anodes (i.e. G anodes and B anodes of the LED particles in the corresponding line) of the green lamp tubes and the blue lamp tubes of the LED particles in the corresponding line in the LED display panel 10.

The driving circuit 33 can be the same as that shown in embodiment 1, and can include a constant current channel group, wherein the constant current channel group includes multiple constant current logic components (which can also be called constant current logic circuits); and a second end (i.e. input end) of each constant current logic component serves as one of input pins of the display driving circuit 30 respectively, first ends (i.e. output ends) of all the constant current logic components are internally interconnected, and are connected to the grounding end (i.e. GND end) of the display driving circuit 30, and third ends (i.e. control ends) of the constant current logic components are connected with the driving control port of the control circuit 35, and are configured to receive a constant current control signal of the driving circuit 33.

In the implementation mode, the anode of the red lamp tube in the ith LED particle in each line in the LED display panel 10 is connected in parallel with the ith joint, and each joint in each line is connected in parallel, and is connected with the drain of a corresponding P-MOS transistor in the first switching sub-circuit 31 respectively; the anodes of the green lamp tube and the anodes of the blue lamp tube in the jth LED particle in each line are connected in parallel with the jth joint, and each joint in each line is connected in parallel, and is connected to the drain of a corresponding P-MOS transistor in the second switching sub-circuit 31 respectively; the cathodes of the LEDs in the same primary colors in each LED particle in each column are interconnected to the input ends of the constant current logic components in the constant current channel group of the display driving circuit 30, that is, the common cathode of the red lamp tubes (i.e. R display units) in the LED particles in each column is interconnected to the input end of the corresponding constant current logic component of the constant current channel group of the display driving circuit 30; the common cathode of the green lamp tubes (i.e. G display units) in the LED particles in each column is interconnected to the input end of the constant current logic component of the constant current channel group of the display driving circuit 30; and the common cathode of the blue lamp tubes (i.e. B display units) in the LED particles in each column is interconnected to the input end of the constant current logic component of the constant current channel group of the display driving circuit 30.

In the implementation mode, power supply voltages of the first switching sub-circuit and the second switching sub-circuit can be different, a power supply voltage of VCCB is preferably 1.6V, and can be lower than that of the pin VCCA, and 1.6V is obtained by subtracting a typical working voltage (1.8-2V) of the red lamp tubes from typical working voltages (3.4-3.6V) of the green and blue lamp tubes, so that the power supply voltages of the R/G/B LEDs are differentially controlled to further reduce the power consumption of the LED display.

In the implementation mode, the power supply control circuit 351 of the display driving circuit 30 controls the corresponding P-MOS transistors corresponding to the same lines in the first switching sub-circuit and the second switching sub-circuit to be in an on state through the power supply control port respectively to supply power to the anodes of the R LEDs and the G/B LEDs of the LED particles in the corresponding lines on the LED display panel 10, and the driving control circuit 353 outputs an R display control signal/G display control signal/B display control signal to each constant current logic component in the first constant current channel group/second constant current channel group/third constant current channel group through the first R display control sub-port/first G display control sub-port/first B display control sub-port to control each constant current logic component in the three constant current channel groups to be in an on working state respectively, thereby providing the current paths for the R cathodes, G cathodes and B cathodes of the LED particles in the corresponding columns and realizing the ordered display of the LED particles.

Based on the technical solution shown in the first transformed implementation mode of embodiments 3 and 4, there can also be a transformed mode as follows:
the LED display panel 10 can also be implemented by an implementation mode as follows: the field effect transistors can be P-MOS transistors, the LED display panel 10 can include M lines and N columns of LED particles, and each LED particle respectively includes an red lamp tube, a green lamp tube and a blue lamp tube, wherein the cathode of the red lamp tube in each LED particle in each line is connected in parallel, and is connected with the drain of a corresponding P-MOS transistor in the first switching sub-circuit; the anodes of the green lamp tube and the anodes of the blue lamp tube in each LED particle in each line are connected in parallel, and are connected with the drain of a corresponding P-MOS transistor in the second switching sub-circuit; the cathode of the red lamp tube of each LED particle in each column is connected in parallel, and is connected with the second end of a corresponding constant current logic component in the constant current channel group respectively; the cathode of the green lamp tube of each LED particle in each column is connected in parallel, and is connected with the second end of a corresponding constant current logic component in the constant current channel group respectively; and the cathode of the blue lamp tube of each LED particle in each column is connected in parallel, and is connected with the second end of a corresponding constant current logic component in the constant current channel group respectively.

Specifically, the anode of the red lamp tube in each LED particle in each line in the LED display panel 10 is connected in parallel with the drain of a corresponding P-MOS transistor in the first switching sub-circuit; the anodes of the green lamp tube and the anodes of the blue lamp tube in each LED particle in each line are connected in parallel with the drain of a corresponding P-MOS transistor in the second switching sub-circuit; the cathodes of the LEDs in the same primary colors in the LED particles in each column are interconnected to the input ends of the constant current logic components of the constant current channel group of the display driving circuit 30, that is, the common cathode of the R LEDs in the LED particles in each column is interconnected to the input end of the constant current logic component of the constant current channel group of the display driving circuit 30; the common cathode of the G LEDs in the LED particles in each column is interconnected to the input end of the constant current logic component of the constant current channel group of the display driving circuit 30; and the common cathode of the B LEDs in the LED particles in each column is interconnected to the input end of the constant current logic component of the constant current channel group of the display driving circuit 30.

Based on the technical solution shown in the first transformed implementation mode of embodiments 3 and 4, there can also be two implementation modes as follows:
first: the field effect transistors can be N-MOS transistors, the LED display panel 10 includes M lines and N columns of LED particles, and each LED particle includes an red lamp tube, a green lamp tube and a blue lamp tube, wherein the cathode of the red lamp tube in each LED particle in each line is connected in parallel, and is connected with the drain of a corresponding N-MOS transistor in the first switching sub-circuit; the cathodes of the green lamp tube and the cathodes of the blue lamp tube in each LED particle in each line are connected in parallel, and are connected with the drain of a corresponding N-MOS transistor in the second switching sub-circuit; the anode of the red lamp tube of each LED particle in each column is connected in parallel, and is connected with the second end of a corresponding constant current logic component in the constant current channel group; the anode of the green lamp tube of each LED particle in each column is connected in parallel, and is connected with the second end of a corresponding constant current logic component in the constant current channel group respectively; and the anode of the blue lamp tube of each LED particle in each column is connected in parallel, and is connected with the second end of a corresponding constant current logic component in the constant current channel group respectively.
Second: the field effect transistors are N-MOS transistors, the LED display panel 10 includes M lines and N columns of LED particles, and each LED particle includes an red lamp tube, a green lamp tube and a blue lamp tube, wherein the cathode of the red lamp tube in the ith LED particle in each line is connected in parallel with the ith joint, and each joint in each line is connected in parallel, and is connected with the drain of a corresponding N-MOS transistor in the first switching sub-circuit 31; the cathodes of the green lamp tube and the cathodes of the blue lamp tube in the jth LED particle in each line are connected in parallel with the jth joint, and each joint in each line is connected in parallel, and is connected to the drain of a corresponding N-MOS transistor in the second switching sub-circuit 31; the anode of the red lamp tube of each LED particle in each column is connected in parallel, and is connected with the second end of a corresponding constant current logic component in the constant current channel group respectively; the anode of the green lamp tube of each LED particle in each column is connected in parallel, and is connected with the second end of a corresponding constant current logic component in the constant current channel group respectively; and the anode of the blue lamp tube of each LED particle in each column is connected in parallel, and is connected with the second end of a corresponding constant current logic component in the constant current channel group respectively.

In the embodiment, the display driving circuit 30 integrates the first switching sub-circuit and the second switching sub-circuit, each of the two switching sub-circuits 31 includes one or more N-MOS transistors, the sources of the N-MOS transistor of the first switching sub-circuit is interconnected as an external pin GND of the display driving circuit 30, and is connected to a connection terminal of the power end of the power supply equipment, the gate of each N-MOS transistor is connected to an red power supply control signal of the power supply control port, and the drain of each N-MOS transistor is connected to the anodes (i.e. R anodes of the LED particles in the corresponding line) of the red lamp tubes of the LED particles in the corresponding line in the LED display panel 10; and the source of the N-MOS transistor of the second switching sub-circuit is interconnected as an external pin GND of the display driving circuit 30, and is connected to a connection terminal of the power end of the power supply equipment, the gate of the N-MOS transistor is connected to green and blue power supply control signals of the power supply control port, and the drain of each N-MOS transistor is connected to the anodes (i.e. G anodes and B anodes of the LED particles in the corresponding line) of the green lamp tubes and blue lamp tubes of the LED particles in the corresponding line in the LED display panel 10.

The driving circuit 33 can be the same as that shown in embodiment 1, and can include a constant current channel group, wherein the constant current channel group includes multiple constant current logic components (which can also be called constant current logic circuits); and the second end (i.e. input end) of each constant current logic component serves as one of input pins of the display driving circuit 30 respectively, the first ends (i.e. output ends) of all the constant current logic components are internally interconnected, and are connected to the power end of the power supply equipment as the VCC end of the display driving circuit 30, and the third ends (i.e. control ends) of the constant current logic components are connected with the driving control port of the control circuit 35, and are configured to receive a constant current control signal of the driving circuit 33.

Specifically, in the first implementation mode of the transformed mode, the cathode of the red lamp tube of the ith LED particle in each line is connected to the ith joint, and each joint in each line is connected in parallel, and is connected to the drain of a corresponding N-MOS transistor in the first switching sub-circuit respectively; the cathodes of the green lamp tube and the cathodes of the blue lamp tube in the jth LED particle in each line are connected in parallel with the jth joint, and each joint in each line is connected in parallel, and is connected with the drain of a corresponding N-MOS transistor in the second switching sub-circuit; the common anode of the R LEDs in the LED particles in each column is interconnected to the input end of the constant current logic component of the constant current channel group; the common anode of the G LEDs in the LED particles in each column is interconnected to the input end of the constant current logic component of the constant current channel group; and the common anode of the B LEDs in the LED particles in each column is interconnected to the input end of the constant current logic component of the constant current channel group.

In the second implementation mode, the cathode of the red lamp tube in each LED particle in each line is internally interconnected, and is connected with the drain of a corresponding N-MOS transistor in the first switching sub-circuit, and the cathodes of the green and blue lamp tubes in each LED particle in each line are interconnected, and are connected with the drain of a corresponding N-MOS transistor in the second switching sub-circuit; the common anode of the R LEDs in the LED particles in each column is interconnected, and is connected to the input end of the constant current logic component of the constant current channel group of the display driving circuit 30; the common anode of the G LEDs in the LED particles in each column is interconnected, and is connected to the input end of the constant current logic component of the constant current channel group; and the common anode of the B LEDs in the LED particles in each column is interconnected, and is connected to the input end of the constant current logic component of the constant current channel group.

### Embodiments 5 and 6:

Specifically, a switching circuit 31 of a display driving circuit 30 includes a first switching sub-circuit and a second switching sub-circuit, and a driving circuit 33 includes a first constant current channel group, a second constant current channel group and a third constant current channel group, wherein structures of the first switching sub-circuit and the second switching sub-circuit can be the same as those in the first implementation mode in embodiment 1; the first constant current channel group can include one or more constant current logic components, a first end of each constant current logic component is connected with a power end or grounding end of the power supply equipment, a third end of each constant current logic component is connected with a first R display control sub-port of a driving control port, and a second end of each constant current logic component is connected with an anode or cathode of an red lamp tube in each LED particle in a corresponding column in an LED display panel 10, and is configured to control the display of the red lamp tubes of the LED display panel 10; the second constant current channel group includes one or more constant current logic components, a first end of each constant current logic component is connected with the power end or grounding end of the power supply equipment, a third end of each constant current logic component is connected with a first G display control sub-port of the driving control port, and a second end of each constant current logic component is connected with an anode or cathode of a green lamp tube in each LED particle in the corresponding column in the LED display panel 10, and is configured to control the display of the green lamp tubes of the LED display panel 10; and the third constant current channel group includes one or more constant current logic components, a first end of each constant current logic component is connected with the power end or grounding end of the power supply equipment, a third end of each constant current logic component is connected with a first B display control sub-port of the driving control port, and a second end of each constant current logic component is connected with an anode or cathode of a blue lamp tube in each LED particle in the corresponding column in the LED display panel 10, and is configured to control the display of the blue lamp tubes of the LED display panel 10. Wherein, the first constant current channel group can be an R constant current channel group, the second constant current channel group can be G constant current channel group, and the third constant current channel group can be a B constant current channel group.

Specifically, a power supply control circuit 351 in the control circuit 35 is configured to control a field effect transistor in the first switching sub-circuit to be switched on to supply power to the red lamp tubes in the LED particles in the line corresponding to the field effect transistor in the first switching sub-circuit in the LED display panel 10; the power supply control circuit 351 is further configured to control the field effect transistor corresponding to each field effect transistor in the first switching sub-circuit in the second switching sub-circuit to be switched on to supply power to the green lamp tubes and the blue lamp tubes in the LED particles in the line corresponding to the field effect transistor in the first switching sub-circuit in the LED display panel 10; the driving control circuit 353 is configured to control each constant current logic component in the first constant current channel group to be switched on through the first R display control sub-port, and each constant current logic component provides a current path for the red lamp tubes in the LED particles in the column corresponding to the constant current logic component in the LED display panel 10 to control the display of the red lamp tubes of the LED particles in the line corresponding to the field effect transistor in the LED display panel 10 after being switched on; the driving control circuit 353 is further configured to control each constant current logic component in the second constant current channel group to be switched on through the first G display control sub-port, and each constant current logic component provides a current path for the green lamp tubes in the LED particles in the column corresponding to the constant current logic component in the LED display panel 10 to control the display of the green lamp tubes of the LED particles in the line corresponding to the field effect transistor in the LED display panel 10 after being switched on; and the driving control circuit 353 is further configured to control each constant current logic component in the third constant current channel group to be switched on through the first B display control sub-port, and each constant current logic component provides a current path for the blue lamp tubes in the LED particles in the column corresponding to the constant current logic component in the LED display panel 10 to control the display of the blue lamp tubes of the LED particles in the line corresponding to the field effect transistor in the LED display panel 10 after being switched on.

Wherein, the three constant current channel groups in the embodiment control the constant current display of the red lamp tubes, the green lamp tubes and the blue lamp tubes (which can be R/G/B LEDs) on the LED display panel 10 respectively, the first switching sub-circuit 31 and the second switching sub-circuit 31 (each of the two switching sub-circuits 31 can be a group of channels consisting of P-MOS transistors, called P-MOS channels for short) in the switching circuit 31 are configured to control the power supply of the R/G/B LEDs on the LED display panel 10 respectively, and the power supply control circuit 351 and the driving control circuit 353 in the display driving circuit 30 control working states of the switching circuit 31 and the driving circuit 33 respectively.

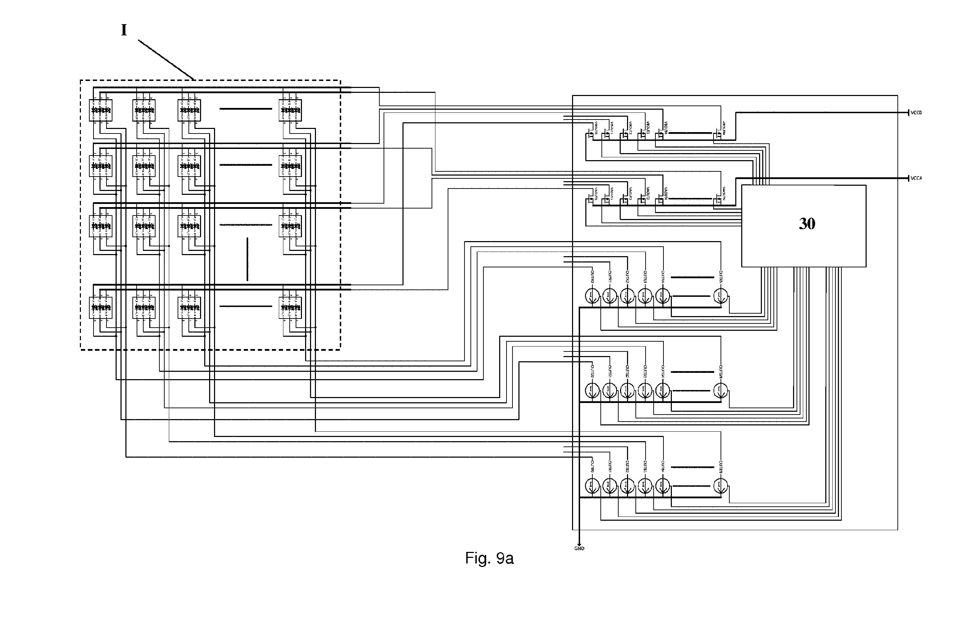

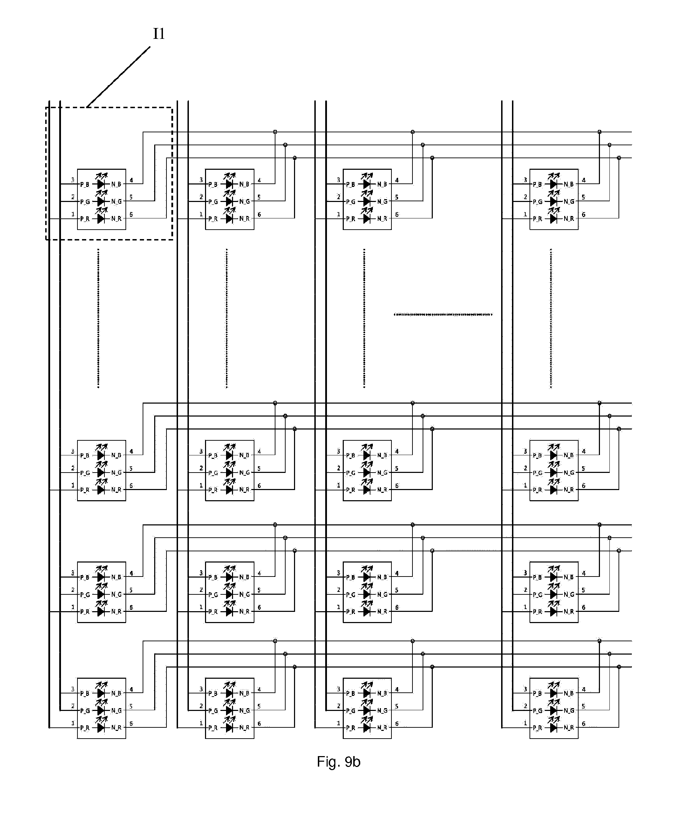

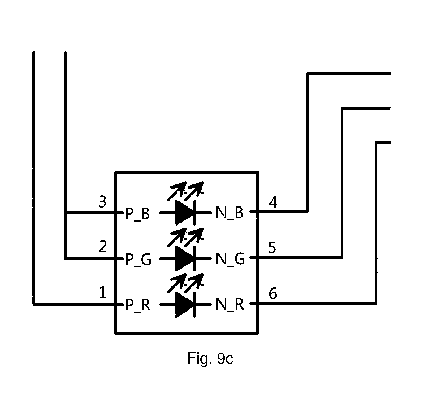

Correspondingly, the power supply control port includes a first power supply control port and a second power supply control port, wherein the first power supply control port is configured to transmit a first power supply control signal to the first switching sub-circuit (i.e. VCCB-powered P-MOS channel group shown in Fig. 9), and the second power supply control port is configured to transmit a second power supply control signal to the second switching sub-circuit (i.e. VCCA-powered P-MOS channel group); and the driving control port includes a second R/G/B display control sub-port which transmits second R/G/B display control signals to the R/G/B constant current channel groups.

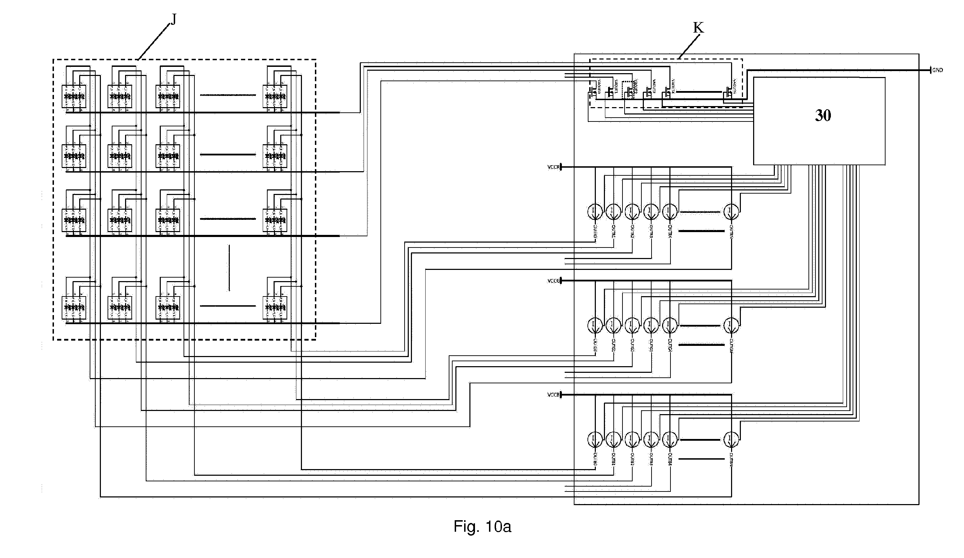

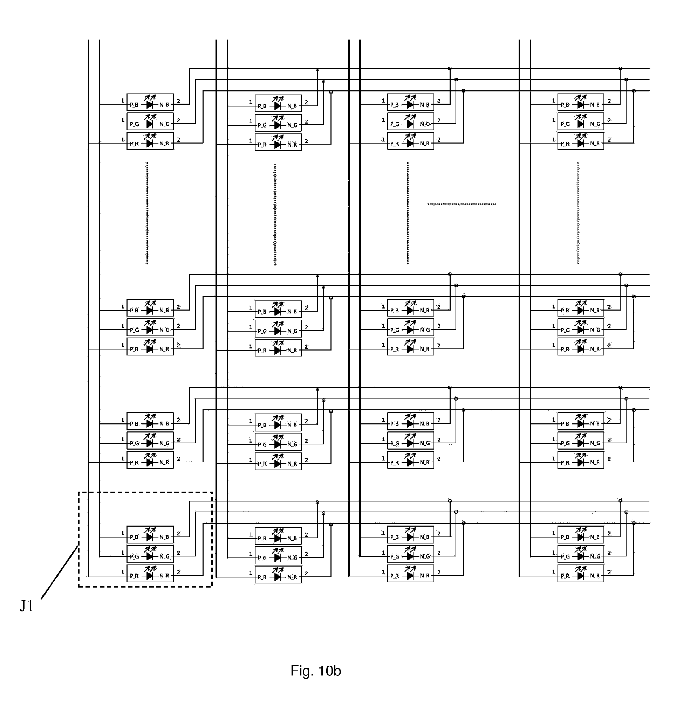

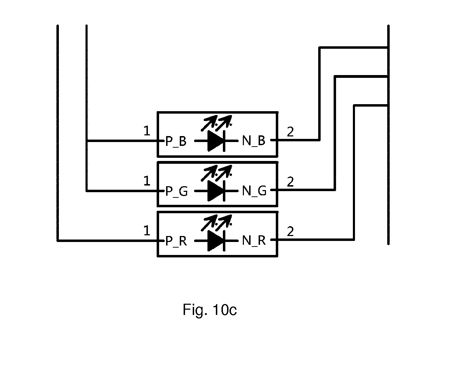

Fig. 9a to Fig. 9c are structure diagrams of an LED display according to embodiment 7 of the invention, and Fig. 10a to Fig. 10e are structure diagrams of an LED display according to embodiment 7 of the invention. Fig. 9b and Fig. 10b show drawings of partial enlargement of a part I covered by a dotted line in Fig. 9a and a part J covered by a dotted line in Fig. 10a in the two embodiments respectively, LEDs in three primary colors in an LED particle in Fig. 9c are directly integrated on the LED particle, the LEDs in the three primary colors in each LED particle in Fig. 10c are encapsulated and integrated on the LED particle respectively, but beyond that, the same circuit connection relationship can be adopted in the two implementation modes. Wherein, the anode of each LED particle in Fig. 9c and Fig. 9b has three pins, i.e. 1, 2 and 3 respectively, corresponding to the anodes of the internal R/G/B LEDs respectively, and the cathode of each LED particle in Fig. 9c and Fig. 9b has three pins, i.e. 4, 5 and 6 respectively, corresponding to the cathodes of the internal B/G/R LEDs respectively; and as shown in Fig. 10c, the anodes of the R/G/B LEDs are pins 1, the cathodes of the R/G/B LEDs are pins 2, and the R/G/B LEDs are welded in parallel as the LED particles (i.e. full-color pixels).

Specifically, the display driving circuit 30 integrates three constant current channel groups which control the constant current display of the R/G/B LEDs on the LED display panel 10 respectively, integrates two groups of P-MOS channels which are configured to control the power supply of the R/G/B LEDs on the LED display panel respectively, and integrates the control circuit 35 which is configured to control the coordinated work of the constant current channel groups and the P-MOS transistor channels.

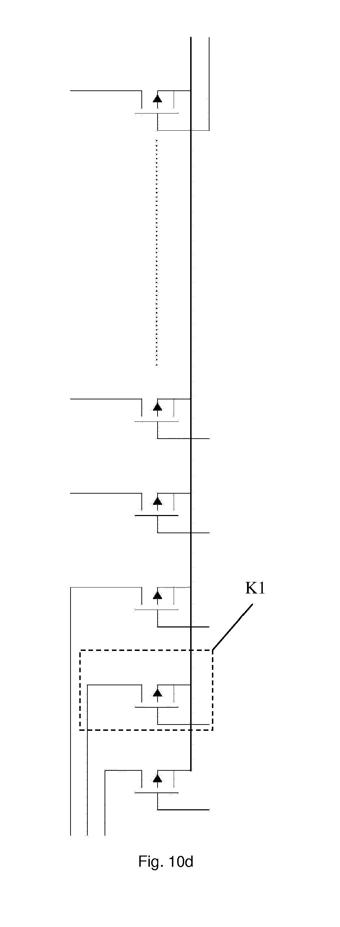

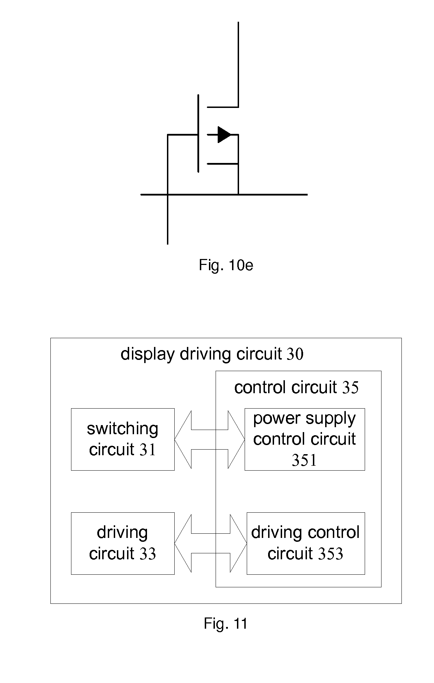

In embodiments 5 and 6, as shown in Fig. 10d, the field effect transistors on the part K covered by the dotted line in Fig. 10a can be P-MOS transistors, Fig. 10e shows the structure of the P-MOS transistor on the part K1 covered by the dotted line in Fig. 10d, the LED display panel 10 includes M lines and N columns of LED particles, and each LED particle includes an red lamp tube, a green lamp tube and a blue lamp tube, wherein the anode of the red lamp tube in each LED particle in each line is connected in parallel, and is connected with the drain of a corresponding P-MOS transistor in the first switching sub-circuit respectively; the anodes of the green lamp tube and the blue lamp tube in each LED particle in each line are connected in parallel, and are connected with the drain of a corresponding P-MOS transistor in the second switching sub-circuit as connection terminals of the anode of the LED display panel 10; the cathode of the red lamp tube of each LED particle in each column is connected in parallel, and is connected with the second end of a corresponding constant current logic component in the first constant current channel group respectively; the cathode of the green lamp tube of each LED particle in each column is connected in parallel, and is connected with the second end of a corresponding constant current logic component in the second constant current channel group respectively; and the cathode of the blue lamp tube of each LED particle in each column is connected in parallel, and is connected with the second end of a corresponding constant current logic component in the third constant current channel group respectively.

The first switching sub-circuit includes one or more P-MOS transistors, the sources of these P-MOS transistors are interconnected to an external pin VCCB of the display driving circuit 30 (3024), the gates of the P-MOS transistors are connected to the first power supply control port, and the drains of the P-MOS transistors are connected to the R anodes of the LED particles in the corresponding lines in the LED display panel 10 (the LED particles in a single line or in multiple lines in Fig. 9a); and the second switching sub-circuit includes one or more P-MOS transistors, the sources of these P-MOS transistors are interconnected to an external pin VCCA of the display driving circuit 30 (3024), the gates of the P-MOS transistors are connected to the second power supply control port, and the drains of the P-MOS transistors are connected to the G and B anodes of the LED particles in the corresponding lines in the LED display panel 10 (the LED particles in a single line or in multiple lines in Fig. 9a).

In addition, the R constant current channel group can include one or more constant current logic components, the input ends of these constant current logic components are connected to the R cathodes of the LED particles in the corresponding columns in the LED display panel 10, the output ends of the constant current logic components are interconnected to the external pin GND of the display driving circuit 30, and the control ends of the constant current logic circuits are connected to the first R display control sub-port; the G constant current channel group can include one or more constant current logic components, the input ends of these constant current logic components are connected to the G cathodes of the LED particles in the corresponding columns in the LED display panel 10, the output ends of the constant current logic components are interconnected to the external pin GND of the display driving circuit 30, and the control ends of the constant current logic circuits are connected to the first G display control sub-port; and the B constant current channel group can include one or more constant current logic components, the input ends of these constant current logic components are connected to the B cathodes of the LED particles in the corresponding columns in the LED display panel 10, the output ends of the constant current logic components are interconnected to the external pin GND of the display driving circuit 30, and the control ends of the constant current logic circuits are connected to the first B display control sub-port.

Under the control of the display driving circuit 30, the power supply control circuit 351 controls the corresponding two P-MOS transistors corresponding to the same line in the first switching sub-circuit 31 and the second switching sub-circuit 31 to be in an on state through the power supply control port to supply power to the anodes of the R LEDs and the G/B LEDs of the LED particles in the corresponding line on the LED display panel 10, and the driving control circuit 353 outputs an R display control signal/G display control signal/B display control signal to each constant current logic component in the first constant current channel group/second constant current channel group/third constant current channel group through the second R display control sub-port/second G display control sub-port/second B display control sub-port to control each constant current logic component in the three constant current channel groups to be in an on working state respectively, thereby providing the current paths for the R cathodes, G cathodes and B cathodes of the LED particles in the corresponding columns and realizing the ordered display of the LED particles.

In the implementation mode, power supply voltages of the first switching sub-circuit and the second switching sub-circuit can be different, a power supply voltage of VCCB is preferably 1.6V, and can be lower than that of the pin VCCA, and 1.6V is obtained by subtracting a typical working voltage (1.8-2V) of the red lamp tubes from typical working voltages (3.4-3.6V) of the G and blue lamp tubes, so that the power supply voltages of the R/G/B LEDs can be differentially controlled to further reduce the power consumption of the LED display.

In addition, the implementation modes shown in embodiments 5 and 6 can also be transformed as follows:
the field effect transistors in the LED display can be P-MOS transistors, the LED display panel 10 can include M lines and N columns of LED particles, and each LED particle includes an red lamp tube, a green lamp tube and a blue lamp tube, wherein the anode of the red lamp tube in the ith LED particle in each line is connected in parallel with the ith joint, and each joint in each line is connected in parallel, and is connected with the drain of a corresponding P-MOS transistor in the first switching sub-circuit 31; the anodes of the green lamp tube and the anodes of the blue lamp tube in the jth LED particle in each line are connected in parallel with the jth joint, and each joint in each line is connected in parallel, and is connected with the drain of a corresponding P-MOS transistor in the second switching sub-circuit 31; the cathode of the red lamp tube of each LED particle in each column is connected in parallel, and is connected with the second end of a corresponding constant current logic component in the first constant current channel group respectively; the cathode of the green lamp tube of each LED particle in each column is connected in parallel, and is connected with the second end of a corresponding constant current logic component in the second constant current channel group respectively; and the cathode of the blue lamp tube of each LED particle in each column is connected in parallel, and is connected with the second end of a corresponding constant current logic component in the third constant current channel group.

Furthermore, the power supply voltage of the external pin VCCB of the display driving circuit 30 can be lower than that of the external pin VCCA, and is preferably 1.6V which is obtained by subtracting the typical working voltage (1.8-2V) of the red lamp tubes from the working voltages (3.4-3.6V) of the green and blue lamp tubes, and the power supply voltages of the R/G/B LEDs are differentially controlled, thereby reducing the power consumption of the LED display.

Based on the implementation modes shown in embodiments 5 and 6, there can also be two transformations as follows:
the field effect transistors can also be N-MOS transistors, the LED display panel 10 includes M lines and N columns of LED particles, and each LED particle includes an red lamp tube, a green lamp tube and a blue lamp tube, wherein the cathode of the red lamp tube in the ith LED particle in each line is connected in parallel with the ith joint, and each joint in each line is connected in parallel, and is connected with the drain of a corresponding N-MOS transistor in the first switching sub-circuit 31 respectively; the cathodes of the green lamp tube and the cathodes of the blue lamp tube in the jth LED particle in each line are connected in parallel with the jth joint, and each joint in each line is connected in parallel, and is connected with the drain of a corresponding N-MOS transistor in the second switching sub-circuit 31 respectively; the anode of the red lamp tube of each LED particle in each column is connected in parallel, and is connected with the second end of a corresponding constant current logic component in the first constant current channel group respectively; the anode of the green lamp tube of each LED particle in each column is connected in parallel, and is connected with the second end of a corresponding constant current logic component in the second constant current channel group respectively; and the anode of the blue lamp tube of each LED particle in each column is connected in parallel, and is connected with the second end of a corresponding constant current logic component in the third constant current channel group respectively.

Specifically, in the embodiment, the first switching sub-circuit includes one or more N-MOS transistors, the sources of these N-MOS transistors are interconnected to the external pin GND of the display driving circuit 30, the gates of the N-MOS transistors are connected to the first power supply control port, and the drains of the N-MOS transistors are connected to the R anodes of the LED particles in the corresponding lines in the LED display panel 10 (the LED particles in a single line or in multiple lines in Fig. 10a); and the second switching sub-circuit includes one or more N-MOS transistors, the sources of these N-MOS transistors are interconnected to the external pin GND of the display driving circuit 30, the gates of the N-MOS transistors are connected to the second power supply control port, and the drains of the N-MOS transistors are connected to the G and B anodes of the LED particles in the corresponding lines in the LED display panel 10 (the LED particles in a single line or in multiple lines in Fig. 10a).

In addition, the R constant current channel group can include one or more constant current logic components, the input ends of these constant current logic components are connected to the R cathodes of the LED particles in the corresponding columns in the LED display panel 10, the output ends of the constant current logic components are interconnected to the external pin VCCR of the display driving circuit 30, and the control ends of the constant current logic circuits are connected to the first R display control sub-port; the G constant current channel group can include one or more constant current logic components, the input ends of these constant current logic components are connected to the G cathodes of the LED particles in the corresponding columns in the LED display panel 10, the output ends of the constant current logic components are interconnected to the external pin VCCG of the display driving circuit 30, and the control ends of the constant current logic circuits are connected to the first G display control sub-port; and the B constant current channel group can include one or more constant current logic components, the input ends of these constant current logic components are connected to the B cathodes of the LED particles in the corresponding columns in the LED display panel 10, the output ends of the constant current logic components are interconnected to the external pin VCCB of the display driving circuit 30, and the control ends of the constant current logic circuits are connected to the first B display control sub-port.

Wherein, the power supply voltage of the external pin VCCR is lower than that of the external pin VCCR/VCCB, and is preferably 1.6V which is obtained by subtracting the typical working voltage (1.8-2V) of the red lamp tubes from the typical working voltages (3.4-3.6V) of the G and blue lamp tubes, and the power supply voltages of the R/G/B LEDs are differentially controlled, thereby reducing the power consumption of the LED display.

Specifically, the cathode of the red lamp tube in the ith LED particle in each line is connected in parallel with the ith joint, and each joint in each line is connected in parallel, and is connected with the drain of a corresponding N-MOS transistor in the first switching sub-circuit 31 respectively; the cathodes of the green lamp tube and the blue lamp tube in the jth LED particle in each line are connected in parallel with the jth joint, and each joint in each line is connected in parallel, and is connected with the drain of a corresponding N-MOS transistor in the second switching sub-circuit 31 respectively; the common anode of the R LEDs in the LED particles in each column is interconnected to the input end of the constant current logic component of the first constant current channel group of the display driving circuit 30 respectively; the common anode of the G LEDs of the LED particles in each column is interconnected to the input end of the constant current logic component of the second constant current channel group of the display driving circuit 30; and the common anode of the B LEDs of the LED particles in each column is interconnected to the input end of the constant current logic component of the third constant current channel group of the display driving circuit 30.

In addition, embodiment 8 can be implemented by a method as follows: the field effect transistors can be N-MOS transistors, the LED display panel 10 includes M lines and N columns of LED particles, and each LED particle includes an red lamp tube, a green lamp tube and a blue lamp tube, wherein the cathode of the red lamp tube in each LED particle in each line is connected in parallel, and is connected with the drain of a corresponding N-MOS transistor in the first switching sub-circuit 31; the cathodes of the green lamp tube and the cathodes of the blue lamp tube in each LED particle in each line are connected in parallel, and are connected with the drain of a corresponding N-MOS transistor in the second switching sub-circuit 31; the anode of the red lamp tube of each LED particle in each column is connected in parallel, and is connected with the second end of a corresponding constant current logic component in the first constant current channel group; the anode of the green lamp tube of each LED particle in each column is connected in parallel, and is connected with the second end of a corresponding constant current logic component in the second constant current channel group; and the anode of the blue lamp tube of each LED particle in each column is connected in parallel, and is connected with the second end of a corresponding constant current logic component in the third constant current channel group.

Specifically, the cathode of the red lamp tube in each LED particle in each line is internally interconnected, and is connected with the drain of a corresponding N-MOS transistor in the first switching sub-circuit, and the cathodes of the blue and blue lamp tubes in each LED particle in each line are interconnected, and are connected with the drain of a corresponding N-MOS transistor in the second switching sub-circuit 31; the common anode of the R LEDs in the LED particles in each column is interconnected, and is connected to the input end of the constant current logic component of the constant current channel group of the display driving circuit 30; the common anode of the G LEDs in the LED particles in each column is interconnected, and is connected to the input end of the constant current logic component of the constant current channel group of the display driving circuit 30; and the common anode of the B LEDs in the LED particles in each column is interconnected, and is connected to the input end of the constant current logic component of the constant current channel group of the display driving circuit 30.

The LED particles in the LED display according to the embodiment of the invention include the red lamp tubes, the green lamp tubes and the blue lamp tubes, wherein the red lamp tubes, the green lamp tubes and the blue lamp tubes can be integrated in the LED particles, and can also be arranged in the LED particles after being independently encapsulated respectively.

In embodiments 1 to 6, the field effect transistors in Fig. 6a, Fig. 7a and Fig. 8a can be the N-MOS transistors shown in Fig. 7c respectively, and the field effect transistors in Fig. 5a, Fig. 9a and Fig. 10a can be the P-MOS transistors shown in Fig. 10c respectively.

Fig. 11 is a structure diagram of an LED control system according to an embodiment of the invention. As shown in Fig. 11, the LED control system includes: a display driving circuit 30, the display driving circuit 30 includes: a switching circuit 31, a driving circuit 33 and a control circuit 35, wherein a first end of one of the switching circuit 31 and the driving circuit 33 is connected to a power end of power supply equipment, and a first end of the other of the switching circuit 31 and the driving circuit 33 is connected to a grounding end of the power supply equipment; a second end of one of the switching circuit 31 and the driving circuit 33 is connected with an anode of an LED display panel 10, and a second end of the other of the switching circuit 31 and the driving circuit 33 is connected to a cathode of the LED display panel 10; the switching circuit 31 is configured to control the power supply of the LED display panel 10, and the driving circuit 33 is configured to control the ordered display of the LED display panel 10; the control circuit includes: a power supply control circuit 351 and a driving control circuit 353, wherein the power supply control circuit 351 is connected with a third end of the switching circuit 31 through a power supply control port, and is configured to control the switching-on or switching-off of the switching circuit 31; and the driving control circuit 353 is connected with a third end of the driving circuit 33 through a driving control port, and is configured to control the switching-on or switching-off of the driving circuit 33.

According to the invention, the display driving circuit 30 in the LED control system includes the switching circuit 31, the driving circuit 33 and the control circuit 35, wherein the control circuit 35 includes the power supply control circuit 351 and the driving control circuit 353; the power supply control circuit 351 is configured to control the switching-on or switching-off of the switching circuit 31; and the driving control circuit 353 is configured to control the switching-on or switching-off of the driving circuit 33, then control the power supply of the LED display panel 10 by switching on or switching off the switching circuit 31 and control the display of the LED display panel 10 by switching on or switching off the driving circuit 33, thereby realizing the ordered display of the LED display panel 10. By the LED control system of the invention, the switching circuit 31, the driving circuit 33 and the control circuit 35 are integrated in the display driving circuit 30, and then more display driving circuits 30 can be placed under the condition of not changing an area of the LED display panel 10, so that a number ratio of the LED particles and the display driving circuits 30 on the LED display with a fixed area is reduced, and a refresh rate is increased; moreover, a connection relationship between the LED particle array with M lines and N columns in the LED display panel and the display driving circuits 30 is clearer, and fewer connection lines are required, so that the design difficulty of a PCB is lowered. The problems of large PCB area occupied by the control circuit 35, low refresh rate and high power consumption of the LED display in related art are solved, and the effects of small PCB area occupied by the control circuit 35, simple design and high refresh rate of the LED display are achieved.

From the above, it can be seen that the invention achieves technical effects as follows: by the LED display of the invention, the driving circuit 33 and the control circuit 35 are integrated in the display driving circuit 30, and then more display driving circuits 30 can be placed under the condition of not changing the area of the LED display panel 10, so that the number ratio of the LED particles and the display driving circuits 30 on the LED display with the fixed area is reduced, and the refresh rate is increased; moreover, the driving circuit 33 includes the first constant current channel group 331, the second constant current channel group 333 and the third constant current channel group 335, and the three constant current channel groups control the ordered display of the R/G/B LEDs in an LED particle array with M lines and N columns in the LED display panel 10 respectively, and provide different working voltages for the red lamp tubes and the green/blue lamp tubes of the LED particles in the LED display panel 10 respectively, so that the power consumption of the LED display can be lowered. The problems of large PCB area occupied by the control circuit 35 and low refresh rate of the LED display in related art are solved, and the effects of small PCB area occupied by the control circuit 35, simple design, high refresh rate and low power consumption of the LED display are achieved.

The above is only the preferred embodiment of the invention and not intended to limit the invention. For those skilled in the art, the invention can have various modifications and variations. Any modifications, equivalent replacements, improvements and the like within the spirit and principle of the invention shall fall within the scope of protection of the invention.

## Claims

1. A Light-Emitting Diode (LED) display, **characterized by**, comprising:
an LED display panel; and
a display driving circuit, the display driving circuit comprises a driving circuit and a control circuit, the driving circuit comprises a first constant current channel group, a second constant current channel group and a third constant current channel group, wherein
the first constant current channel group comprises one or more constant current logic components, wherein a first end of each constant current logic component is connected with a power end of a first power supply equipment respectively, a third end of each constant current logic component is connected with a first Red (R) display control sub-port of a driving control port of the control circuit respectively, and a second end of each constant current logic component is connected with a cathode of an red lamp tube in each LED particle in a corresponding column in the LED display panel respectively, and is configured to control display of red lamp tubes of the LED display panel;
the second constant current channel group comprises one or more constant current logic components, wherein a first end of each constant current logic component is connected with a power end of a second power supply equipment respectively, a third end of each constant current logic component is connected with a first Green (G) display control sub-port of the driving control port of the control circuit respectively, and a second end of each constant current logic component is connected with a cathode of a green lamp tube in each LED particle in a corresponding column in the LED display panel respectively, and is configured to control display of green lamp tubes of the LED display panel;
the third constant current channel group comprises one or more constant current logic components, wherein a first end of each constant current logic component is connected with a power end of a third power supply equipment respectively, a third end of each constant current logic component is connected with a first Blue (B) display control sub-port of the driving control port of the control circuit respectively, and a second end of each constant current logic component is connected with a cathode of a blue lamp tube in each LED particle in a corresponding column in the LED display panel respectively, and is configured to control display of blue lamp tubes of the LED display panel;
the control circuit comprises a driving control circuit, wherein the driving control circuit is connected with a third end of the driving circuit through the driving control port, and is configured to control switching-on or switching-off of the driving circuit; and
the driving circuit is configured to control ordered display of the LED display panel.

2. The display according to claim 1, **characterized in that**
the driving control circuit is configured to control each constant current logic component in the first constant current channel group to be switched on through the first R display control sub-port, and each constant current logic component provides a current path for the red lamp tubes in the LED particles in the column corresponding to the constant current logic component in the LED display panel to control the display of the red lamp tubes of the LED particles in the line corresponding to a field effect transistor in the LED display panel after being switched on respectively;
the driving control circuit is further configured to control each constant current logic component in the second constant current channel group to be switched on through the first G display control sub-port, and each constant current logic component provides a current path for the green lamp tubes in the LED particles in the column corresponding to the constant current logic component in the LED display panel to control the display of the green lamp tubes of the LED particles in the line corresponding to the field effect transistor in the LED display panel after being switched on respectively; and
the driving control circuit is further configured to control each constant current logic component in the third constant current channel group to be switched on through the first B display control sub-port, and each constant current logic component provides a current path for the blue lamp tubes in the LED particles in the column corresponding to the constant current logic component in the LED display panel to control the display of the blue lamp tubes of the LED particles in the line corresponding to the field effect transistor in the LED display panel after being switched on respectively.

3. The display according to claim 1, **characterized in that**
the display driving circuit further comprises a switching circuit, wherein a first end of the switching circuit is connected to the grounding end of the power supply equipment, and a second end of the switching circuit is connected with an anode of the LED display panel;
the control circuit further comprises a power supply control circuit, wherein the power supply control circuit is connected with a third end of the switching circuit through a power supply control port, and is configured to control the switching-on or switching-off of the switching circuit; and
the switching circuit is configured to control the power supply of the LED display panel.

4. The display according to claim 3, **characterized in that** the switching circuit comprises one switching sub-circuit, and the switching sub-circuit comprises one or more field effect transistors;
a source of each field effect transistor is connected with grounding end of the power supply equipment respectively;
a drain of each field effect transistor is connected with a cathode of each LED particle in a corresponding line in the LED display panel respectively; and
a gate of each field effect transistor is connected with a corresponding connection terminal in the power supply control port respectively.

5. The display according to claim 4, **characterized in that**
the power supply control circuit is configured to control each field effect transistor to be switched on to supply power to the LED particles in the lines corresponding to the field effect transistors in the LED display panel.

6. The display according to claim 4 or 5, **characterized in that** the field effect transistors are N-channel Metal Oxide Semiconductor (N-MOS) transistors, the LED display panel comprises M lines and N columns of LED particles, and each LED particle comprises the red lamp tube, the green lamp tube and the blue lamp tube respectively;
the cathode of the red lamp tube, the cathode of the green lamp tube and the cathode of the blue lamp tube in an ith LED particle in each line are connected in parallel with an ith joint, and each joint in each line is connected in parallel, and is connected with a drain of a corresponding N-MOS transistor in the switching circuit respectively;
the anode of the red lamp tube of each LED particle in each column is connected in parallel respectively, and is connected with the second end of a corresponding constant current logic component in the first constant current channel group as a connection terminal of the anode of the LED display panel respectively;
the anode of the green lamp tube of each LED particle in each column is connected in parallel respectively, and is connected with the second end of a corresponding constant current logic component in the second constant current channel group as a connection terminal of the anode of the LED display panel respectively; and
the anode of the blue lamp tube of each LED particle in each column is connected in parallel respectively, and is connected with the second end of a corresponding constant current logic component in the third constant current channel group as a connection terminal of the anode of the LED display panel respectively.

7. The display according to claim 4 or 5, **characterized in that** the field effect transistors are N-MOS transistors, the LED display panel comprises M lines and N columns of LED particles, and each LED particle comprises the red lamp tube, the green lamp tube and the blue lamp tube respectively;
the cathode of the red lamp tube, the cathode of the green lamp tube and the cathode of the blue lamp tube in each LED particle in each line are connected in parallel, and are connected with the drain of a corresponding N-MOS transistor in the switching circuit respectively;
the anode of the red lamp tube of each LED particle in each column is connected in parallel respectively, and is connected with the second end of a corresponding constant current logic component in the first constant current channel group respectively;
the anode of the green lamp tube of each LED particle in each column is connected in parallel respectively, and is connected with the second end of a corresponding constant current logic component in the second constant current channel group; and
the anode of the blue lamp tube of each LED particle in each column is connected in parallel respectively, and is connected with the second end of a corresponding constant current logic component in the third constant current channel group respectively.

8. The display according to claim 3, **characterized in that** the switching circuit comprises a first switching sub-circuit and a second switching sub-circuit;
the first switching sub-circuit comprises one or more field effect transistors, a source of each field effect transistor is connected with the grounding end of the power supply equipment respectively, a drain of each field effect transistor is connected with the cathode of the red lamp tube in each LED particle in the corresponding line in the LED display panel respectively, and a gate of each field effect transistor is connected with the corresponding connection terminal in the power supply control port respectively, and is configured to control the power supply of the red lamp tubes of the LED display panel; and
the second switching sub-circuit comprises one or more field effect transistors, a source of each field effect transistor is connected with the grounding end of the power supply equipment respectively, a drain of each field effect transistor is connected with the cathodes of the green lamp tube and the blue lamp tube in each LED particle in the corresponding line in the LED display panel respectively, and a gate of each field effect transistor is connected with the corresponding connection terminal in the power supply control port, and is configured to control the power supply of the green lamp tubes and the blue lamp tubes of the LED display panel.

9. The display according to claim 8, **characterized in that**
the power supply control circuit is configured to control one field effect transistor in the first switching sub-circuit to be switched on to supply power to the red lamp tubes in the LED particles in the line corresponding to the field effect transistor in the first switching sub-circuit in the LED display panel;
the power supply control circuit is further configured to control the field effect transistor corresponding to the switched-on field effect transistor in the first switching sub-circuit in the second switching sub-circuit to be switched on to supply power to the green lamp tubes and the blue lamp tubes in the LED particles in the line corresponding to the field effect transistor in the first switching sub-circuit in the LED display panel;
the driving control circuit is configured to control each constant current logic component in the first constant current channel group to be switched on through a second R display control sub-port, and each constant current logic component provides a current path for the red lamp tubes in the LED particles in the column corresponding to the constant current logic component in the LED display panel to control the display of the red lamp tubes of the LED particles in the line corresponding to the field effect transistor in the LED display panel respectively after being switched on;
the driving control circuit is further configured to control each constant current logic component in the second constant current channel group to be switched on through a second G display control sub-port, and each constant current logic component provides a current path for the green lamp tubes in the LED particles in the column corresponding to the constant current logic component in the LED display panel to control the display of the green lamp tubes of the LED particles in the line corresponding to the field effect transistor in the LED display panel respectively after being switched on; and
the driving control circuit is further configured to control each constant current logic component in the third constant current channel group to be switched on through a second B display control sub-port, and each constant current logic component provides a current path for the blue lamp tubes in the LED particles in the column corresponding to the constant current logic component in the LED display panel to control the display of the blue lamp tubes of the LED particles in the line corresponding to the field effect transistor in the LED display panel respectively after being switched on.

10. The display according to claim 8 or 9, **characterized in that** the field effect transistors are N-MOS transistors, the LED display panel comprises M lines and N columns of LED particles, and each LED particle comprises the red lamp tube, the green lamp tube and the blue lamp tube;
the cathode of the red lamp tube in the ith LED particle in each line is connected in parallel with an ith joint, and each joint in each line is connected in parallel, and is connected with the drain of a corresponding N-MOS transistor in the first switching sub-circuit respectively;
the cathode of the green lamp tube and the cathode of the blue lamp tube in a jth LED particle in each line are connected in parallel with a jth joint, and each joint in each line is connected in parallel, and is connected with the drain of a corresponding N-MOS transistor in the second switching sub-circuit respectively;
the anode of the red lamp tube of each LED particle in each column is connected in parallel, and is connected with the second end of a corresponding constant current logic component in the first constant current channel group respectively;
the anode of the green lamp tube of each LED particle in each column is connected in parallel, and is connected with the second end of a corresponding constant current logic component in the second constant current channel group respectively; and
the anode of the blue lamp tube of each LED particle in each column is connected in parallel, and is connected with the second end of a corresponding constant current logic component in the third constant current channel group respectively.

11. The display according to claim 8 or 9, **characterized in that** the field effect transistors are N-MOS transistors, the LED display panel comprises M lines and N columns of LED particles, and each LED particle comprises the red lamp tube, the green lamp tube and the blue lamp tube;
the cathode of the red lamp tube in each LED particle in each line is connected in parallel, and is connected with the drain of a corresponding N-MOS transistor in the first switching sub-circuit respectively;
the cathode of the green lamp tube and the cathode of the blue lamp tube in each LED particle in each line are connected in parallel, and are connected with the drain of a corresponding N-MOS transistor in the second switching sub-circuit respectively;
the anode of the red lamp tube of each LED particle in each column is connected in parallel, and is connected with the second end of a corresponding constant current logic component in the first constant current channel group respectively;
the anode of the green lamp tube of each LED particle in each column is connected in parallel, and is connected with the second end of a corresponding constant current logic component in the second constant current channel group respectively; and
the anode of the blue lamp tube of each LED particle in each column is connected in parallel, and is connected with the second end of a corresponding constant current logic component in the third constant current channel group respectively.

12. The display according to claim 1, **characterized in that** the LED particles in the LED display panel comprise the red lamp tubes, the green lamp tubes and the blue lamp tubes;
the red lamp tubes, the green lamp tubes and the blue lamp tubes are integrated in the LED particles; or
the red lamp tubes, the green lamp tubes and the blue lamp tubes are arranged in the LED particles after being independently encapsulated respectively.
